(19) Europäisches Patentamt
European Patent Office
Office européen des brevets

(11) **EP 2 299 299 A1**

(12) **EUROPEAN PATENT APPLICATION**
published in accordance with Art. 153(4) EPC

(43) Date of publication:
**23.03.2011 Bulletin 2011/12**

(51) Int Cl.:
***G02B 5/30*** (2006.01)      ***C23C 14/06*** (2006.01)

(21) Application number: **09794503.4**

(22) Date of filing: **09.07.2009**

(86) International application number:
**PCT/JP2009/062550**

(87) International publication number:
**WO 2010/005059 (14.01.2010 Gazette 2010/02)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**
Designated Extension States:
**AL BA RS**

(30) Priority: **10.07.2008 JP 2008180448**

(71) Applicant: **Asahi Glass Company Limited
Chiyoda-ku
Tokyo 100-8405 (JP)**

(72) Inventors:
• **KAIDA, Yuriko
Tokyo 100-8405 (JP)**

• **SAKAMOTO, Hiroshi
Tokyo 100-8405 (JP)**
• **MIYAGI, Takahira
Tokyo 100-8405 (JP)**
• **TAKAYAMA, Kosuke
Tokyo 100-8405 (JP)**
• **SAKURAI, Hiromi
Tokyo 100-8405 (JP)**
• **SHIDOJI, Eiji
Tokyo 100-8405 (JP)**

(74) Representative: **Perrey, Ralf
Müller-Boré & Partner
Grafinger Strasse 2
81671 München (DE)**

(54) **WIRE GRID TYPE POLARIZER, AND METHOD FOR MANUFACTURING THE POLARIZER**

(57) A wire-grid polarizer having a high polarization separation ability in the visible light region and an improved transmittance in a short wavelength region, and a process for easily producing such a wire-grid polarizer, are provided.

A wire-grid polarizer 10 comprising a light-transmitting substrate 14 having a surface on which a plurality of ridges 12 are formed in parallel with one another at a predetermined pitch; an underlayer 22 made of a metal oxide and present at least on a top portion of each ridge 12; and a metal wire made of a metal layer 24 and present on a surface of the underlayer 22 to cover at least a top portion of each ridge 12.

Fig. 3

EP 2 299 299 A1

**Description**

TECHNICAL FIELD

The present invention relates to a wire-grid polarizer and a process for producing the polarizer.

BACKGROUND ART

As polarizers (they are also referred to as polarizing separation elements) used for image display devices such as liquid crystal display devices, projection TVs or front projectors, and showing polarization separation ability in the visible light region, there are absorption polarizers and reflection polarizers.

An absorption polarizer is, for example, a polarizer having a dichroic dye such as iodine aligned in a resin film. However, since such an absorption polarizer absorbs one of polarized light, its light-utilization efficiency is low.

On the other hand, in a reflection polarizer, reflected light not incident into the polarizer is incident again into the polarizer, whereby the light-utilization efficiency can be improved. For this reason, a demand for such a reflection polarizer for the purpose of achieving high intensity of e.g. liquid crystal display devices, is increased.

As a reflection polarizer, there are a linear polarizer constituted by a lamination of birefringent resins, a circular polarizer constituted by a cholesteric liquid crystal and a wire-grid polarizer.

However, such linear polarizers and circular polarizers have low polarization separation ability. For this reason, a wire-grid polarizer showing high polarization separation ability is attentioned.

A wire-grid polarizer has a construction comprising a light-transmitting substrate having a plurality of parallel fine metallic wires arranged on the substrate. When the pitch of the fine metallic wires is sufficiently shorter than the wavelength of incident light, in the incident light, a component (i.e. p-polarized light) having an electric field vector perpendicular to the fine metallic wires is transmitted, but a component (i.e. s-polarized light) having an electric field vector parallel with the fine metallic wires is reflected.

As wire-grid polarizers showing polarization separation ability in visible light region, the following types are known.

(1) A wire grid polarizer comprising a light-transmitting substrate on which fine metallic wires are formed at a predetermined pitch (Patent Document 1).
(2) A wire grid polarizer comprising a light-transmitting substrate having a surface on which a plurality of ridges are formed at a predetermined pitch and a top face and side faces of such a ridge is covered with a material film of a metal or a metal compound to form a fine metal wire (Patent Document 2).

However, the wire-grid polarizers of the above (1) and (2) are still insufficient in the polarization separation ability.
Further, as a wire-grid polarizer having an improved bright-site contrast, the following one is known.

(3) A wire-grid polarizer comprising a light-transmitting substrate on which fine metallic wires and low reflective members ($SiO_2$, etc.) are formed at a predetermined pitch (Patent Document 3).

However, the wire-grid polarizer of (3) is insufficient in the transmittance in a short wavelength region.

PRIOR ART

PATENT DOCUMENTS

Patent Document 1: JP-A-2005-070456
Patent Document 2: JP-A-2006-003447
Patent Document 3: JP-A-2008-046637

DISCLOSURE OF THE INVENTION

PROBLEMS TO BE SOLVED BY THE INVENTION

The present invention provides a wire-grid polarizer having a high polarization separation ability in the visible light region and having an improved transmittance in a short wavelength region, and a process for easily producing such a wire-grid polarizer.

MEANS FOR SOLVING THE PROBLEMS

The wire-grid polarizer of the present invention comprises a light-transmitting substrate having a surface on which a plurality of ridges are formed in parallel with one another at a predetermined pitch; an underlayer made of a metal oxide and present at least on the top portion of each ridge; and a fine metal wire made of a metal layer and present on a surface of the underlayer to cover at least the top portion of each ridge.
The metal layer may be further present to cover at least a part of each side face of each ridge. Further, the metal layer may be present to cover the entire surface.
Further, the underlayer may be further present on the entire surface of each side face of each ridge. Further, the underlayer may be further present on each surface of the light-transmitting substrate between the ridges.
The metal oxide is preferably $SiO_2$ or $TiO_2$.
The height of the underlayer on the top portion of each ridge is preferably from 1 to 20 nm.
The height of the metal layer covering the top portion of each ridge is preferably at least 30 nm.
Further, the pitch (Pa) of the fine metallic wires is preferably from 50 to 200 nm, and the ratio (Da/Pa) of the width (Da) of each fine metallic wire to the pitch (Pa) is preferably from 0.1 to 0.6.
The process of the present invention is a process for producing a wire-grid polarizer, comprising: vapor-depositing a metal oxide at least on the top portion of each of a plurality of ridges formed in parallel with one another at a predetermined pitch on a surface of a light-transmitting substrate, to form an underlayer made of the metal oxide; and vapor-depositing a metal on a surface of the underlayer so as to cover at least the top portion of each ridge to form a metal layer to form a fine metallic wire.
The underlayer is preferably formed to cover at least the top portion of each ridge by an oblique vapor deposition method using a vacuum vapor deposition method.
Further, the underlayer is preferably formed on the entire surface of each ridge and each surface of the light-transmitting substrate between the ridges. In this case, the underlayer is more preferably formed by a sputtering method.
The metal layer is preferably formed to cover at least a part of each side face of each ridge and the top portion of each ridge. Further, the underlayer is preferably formed to cover the entire surface of each side faces of each ridge and the top portion of each ridge.
Further, the metal layer is preferably formed by an oblique vapor deposition method using a vacuum vapor deposition method.
When the metal layer is formed by an oblique vapor deposition method using a vacuum vapor deposition method, the metal layer is preferably formed under the following conditions:

(A) the metal is vapor-deposited from a direction substantially perpendicular to the longitudinal direction of each ridge and at an angle of $\theta^R$ to the height direction of the ridge;
(B) the metal is vapor-deposited from a direction substantially perpendicular to the longitudinal direction of the ridge and at an angle of $\theta^L$ on the opposite side from the angle $\theta^R$ to the height direction of the ridge;
(C) vapor deposition under the above condition (A) and vapor deposition under the above condition (B) are carried out alternately so that the number of vapor depositions under the above condition (A) is m (wherein m is at least 1) and the number of vapor depositions under the condition (B) is n (wherein n is at least 1), and the total (m+n) becomes at least 3;
(D) the angle $\theta^R$ in the first vapor deposition in the m times of vapor depositions under the above condition (A) satisfies the following formula (IV) and the angle $\theta^L$ in the first vapor deposition in the n times of vapor depositions under the above condition (B) satisfies the following formula (V):

$$15° \leq \theta^R \leq 45° \qquad (IV),$$

and

$$15° \leq \theta^L \leq 45° \qquad (V);$$

and
(E) when the above m is at least 2, the angle $\theta^R_i$ in the i-th time (wherein i is from 2 to m) and $\theta^R_{(i-1)}$ in the (i-1)-th time satisfy the following formula (VI), and when the above n is at least 2, the angle $\theta^L_j$ in the j-th time (wherein j is from 2 to i) satisfy the following formula (VII):

$$\theta^R_i \leqq \theta^R_{(i-1)} \qquad (VI),$$

and

$$\theta^L_i \leqq \theta^L_{(j-1)} \qquad (IV).$$

EFFECTS OF THE INVENTION

The wire-grid polarizer of the present invention shows a high polarization separation ability in the visible light region, and has an improved transmittance in a short wavelength region.

By the process for producing a wire-grid polarizer of the present invention, it is possible to easily produce a wire-grid polarizer showing a high polarization separation ability in the visible light region, and having an improved transmittance in a short wavelength region.

BRIEF EXPLANATION OF THE DRAWINGS

Fig. 1 is a perspective view showing a first embodiment of the wire-grid polarizer of the present invention.
Fig. 2 is a perspective view showing a second embodiment of the wire-grid polarizer of the present invention.
Fig. 3 is a perspective view showing a third embodiment of the wire-grid polarizer of the present invention.
Fig. 4 is a perspective view showing an example of light-transmitting substrate.

MODES FOR CARRYING OUT THE INVENTION

<WIRE-GRID POLARIZER>

A wire-grid polarizer of the present invention comprises a light-transmitting substrate having a surface on which a plurality of ridges are formed in parallel with one another at a predetermined pitch, an underlayer made of a metal oxide and present at least on the top portion of each ridge, and a metal layer present on a surface of the underlayer to cover at least the top portion of each ridge. The metal layer present to cover at least a top portion of each ridge has a linear shape extending in the longitudinal direction of each ridge. Accordingly, the metal layer corresponds to fine metallic wires constituting the wire-grid polarizer.

Here, the dimensions of each ridge, the underlayer and the metal layer of the present invention were measured in a scanning electron microscopic image or a transmission electron microscopic image of a cross section of the wire-grid polarizer.

(LIGHT-TRANSMITTING SUBSTRATE)

The light-transmitting substrate is a substrate having a light-transmittance in a wavelength region to be used for the wire-grid polarizer. The light-transmittance means a property of transmitting light, and the wavelength region is specifically a region of from 400 nm to 800 nm.

In the present invention, each of the ridges is a portion projecting from a surface of the light-transmitting substrate, which is extending in one direction. The ridges may be made of the same material as the material of the surface portion of the light-transmitting substrate and integrally formed with the portion, or it may be made of a light-transmitting material different from the material of the surface portion of the light-transmitting substrate. The ridges are preferably integrally formed with the surface of the light-transmitting substrate and made of the same material as the surface portion of the light-transmitting substrate. Further, the ridges are preferably formed by shaping at least the surface portion of the light-transmitting substrate.

The cross-sectional shape of each ridge in a section perpendicular to the longitudinal direction of the ridge and the principal plane of the light-transmitting substrate, is preferably constant along the longitudinal direction of the ridge, and the cross-sectional shape is preferably substantially constant among a plurality of the ridges. The cross-sectional shape is preferably a shape that rises upwardly with a substantially constant width from a surface of the light-transmitting substrate, or a shape which rises upwardly with reducing width from a surface of the light-transmitting substrate. The shape may be a shape which rises upwardly with a substantially constant width from a surface of the light-transmitting substrate and further rises with reducing width. A specific cross-sectional shape may, for example, be a rectangle, a trapezoid, a triangle, a semi-cycle, a semi-ellipse or a shape wherein an upper portion of a rectangle is semi-circle.

In the present invention, the top portion of a ridge means a portion that is the highest portion of the cross-sectional shape and that continues in the longitudinal direction of the ridge. The top portion of the ridge may be a plane or a line. For example, when the cross-sectional shape is a rectangle or a trapezoid, the top portion is a plane, and when the cross-sectional shape is a triangle or a semi-circle, the top portion is a line. In the present invention, surfaces other than the top portion of a ridge is referred to as side faces (of ridge). Here, a face between two adjacent ridges (a bottom face of a groove between two ridges) is not referred to as a surface of the ridges, but is referred to as a surface of the light-transmitting substrate (between ridges).

The raw material or the material of the light-transmitting substrate may, for example, be a photocurable resin, a thermoplastic resin or a glass, and it is preferably a photocurable resin or a thermoplastic resin from the viewpoint of capability of forming the ridges by an imprint method to be described later, and it is particularly preferably a photocurable resin from the viewpoint of capability of forming the ridges by a photoimprint method and from the viewpoint of excellence in the thermal resistance and durability. The photocurable resin is preferably a resin producible by photoradical polymerization of photocurable composition from the viewpoint of productivity.

The photocurable composition is preferably one which shows a contact angle of at least 90° with water after the composition is photocured to form a cured film. When such a cured film has a contact angle of at least 90° with water, at a time of forming the ridges by a photoimprint method, it is possible to improve a releasing property from a mold, and to achieve a transferring with high accuracy, and to sufficiently exhibit the objective performance of the wire grid polarizer to be obtained. Further, even if the contact angle is high, there is no problem in adhesion of the underlayer.

The thickness of the light-transmitting substrate in a region where the ridges are present (including the thickness of the ridges) is preferably from 0.5 to 100 $\mu$m, more preferably from 1 to 40 $\mu$m. Further, the thickness of the light-transmitting substrate excluding the height of the ridges in the region where the ridges are present, is preferably at least 0.3 $\mu$m, more preferably at least 0.5 $\mu$m. The thickness of the light-transmitting substrate other than the region where the ridges are present, is preferably the thickness substantially equal to the thickness of the light-transmitting substrate in a region where the ridges are present (including the thickness of the ridges), that is, from 0.5 to 1,000 $\mu$m, more preferably from 1 to 40 $\mu$m.

The height of each ridge is preferably from 30 to 500 nm, more preferably from 50 to 300 nm. When the thickness is at least 30 nm, selective formation of the underlayer on a surface of each ridge becomes possible. When the height is at least 500 nm, the incident angle-dependence of the degree of polarization of the wire-grid polarizer becomes small. Further, the height of the ridges is particularly preferably from 80 to 270 nm from the viewpoint of easiness of forming the metal layer by vapor deposition.

(UNDERLAYER)

The underlayer is a layer made of a metal oxide. Since each metal layer needs to be present on a surface of the underlayer, the underlayer is present at least on the top portion of each ridge, and when the metal layer further covers side faces of each ridge other than the top portion of the ridge, the underlayer is present on side faces where the metal layer is present. Further, the underlayer may be present on side faces of each ridge where the metal layer is not present, and the underlayer may be present on each surface of the light-transmitting substrate between the ridges. The underlayer is preferably present on the entire surface of each ridge and the underlayer is more preferably present on the entire surface of each ridge and each surface of the light-transmitting substrate between the ridges. Namely, the underlayer is more preferably present on the entire surface of the light-transmitting substrate where the ridges are present.

As the metal oxide, $SiO_2$, $Al_2O_3$, $TiO_2$, $ZrO_2$, $SnO_2$, etc. may be mentioned. In particular, in order to achieve high transmittance of wire-grid polarizer in a short wavelength region, $SiO_2$ or $TiO_2$ is particularly preferred. Further, when the underlayer is made of a high refractive index material such as $Al_2O_3$, $TiO_2$ or $ZrO_2$, the refractive index difference between a surface of the underlayer not covered with the metal layer and an interface of the underlayer with air or the light-transmitting substrate, becomes large, whereby the transmittance in the short wavelength region can further be increased.

The thickness of the underlayer may be substantially uniform, or it may vary according to portion. For example, the thickness of the underlayer on the top portion of each ridge, side faces of each ridge and each surface of the light-transmitting substrate between the ridges, may be different from one another. For example, the thickness of the underlayer on the top portion of each ridge may be thicker than the thickness of the underlayer on other surfaces. Here, the thickness of the underlayer on the top portion of each ridge means the thickness in the height direction of each ridge, and hereinafter, it is also referred to as the height of the underlayer on the top portion of each ridge.

The height of the underlayer on the top portion of each ridge (thickness in the height direction of the ridge) is preferably from 1 to 20 nm, particularly preferably from 2 to 15 nm. When the thickness is at least 1 nm, the film quality of fine metallic wires improves, and the p-polarized light transmittance of the wire-grid polarizer improves. When the height is at most 20 nm, wavelength dispersion due to interference with the light-transmitting substrate can be suppressed, whereby the p-polarized light transmittance of the wire-grid polarizer improves. The thickness of the underlayer on side faces of each ridge is usually equal to or smaller than the height of the underlayer on the top portion of each ridge. The thickness of the underlayer on side faces of each ridge may become gradually smaller from the top portion towards the bottom. The thickness of the underlayer other than the top portion of each ridge is equal to or smaller than the height of the underlayer at the top portion of each ridge, the thickness is preferably substantially uniform irrespective of the portion, and the thickness is preferably at least 1 nm.

The underlayer is preferably formed by a vapor deposition method. As the vapor deposition method, a physical vapor deposition method (PVD) or a chemical vapor deposition method (CVD) may be mentioned, and among them, a vapor deposition method such as a vacuum vapor deposition method, a sputtering method or an ion implanting method, is preferred. In particular, a vacuum vapor deposition method or a sputtering method is preferred. In the vacuum vapor deposition method, it is easy to control incident direction of fine particles to be deposited, in relation to the light-transmitting substrate, and it is easy to carry out an oblique vapor deposition method to be described later. Meanwhile, in a sputtering method, since incident directions of fine particles can be easily random, whereby the method is suitable for forming a thin film having a uniform thickness on a wavy surface. Accordingly, in a case of selectively forming the underlayer only on the top portion of each ridge or to portion of each ridge and its side faces, use of a vapor deposition method is preferred, and when the underlayer is formed on the entire surface of the light-transmitting substrate where the ridges are present, use of a sputtering method is preferred. Here, as the sputtering method, a reaction sputtering method (such as a method of using a metal target and carrying out sputtering in an oxygen-containing gas to form a metal oxide layer) may be used. Further, among sputtering methods, a sputtering method using particularly high vacuum environment (such as a magnetron sputtering method) can be used for forming the underlayer instead of the vacuum vapor deposition method since control of incident direction is relatively easy in such a sputtering method. Here, in the following explanations, a sputtering method means a commonly used DC sputtering method or a high frequency sputtering method unless otherwise specified.

In a method such as a sputtering method wherein high energy fine particles are generated and such fine particles are made to adhere to surfaces of ridges, the surfaces of the ridges may be eroded by collision of the high energy fine particles in some cases. For example, in a ridge having a rectangular cross-section, its corners are eroded to be round. Further, the width of the ridge is reduced or the height of the ridge is reduced in some cases. Particularly, such an erosion tends to occur when the material of the ridge is a relatively soft material such as a resin. Further, it is considered that such an erosion tends to occur at the upper portion of each ridge where corrosion of the high energy fine particles are more frequent. Accordingly, as a result of formation of the underlayer by e.g. a sputtering method, the shape of each ridge may become different from the shape before formation of the underlayer in some cases. However, such a change of shape is acceptable so long as the change is not extreme. This is because since a wire-grid polarizer basically exhibits its function according to the width and pitch of its fine metallic wires, and so long as the fine metallic wires having a predetermined width and pitch are formed, influence of the shape of each ridge of the light-transmitting substrate on the function of the wire-grid polarizer is small.

(FINE METALLIC WIRE)

In the wire-grid polarizer of the present invention, the fine metallic wires are each constituted by a metal layer covering a surface of a ridge. The metal layer is present on a surface of the underlayer so as to cover at least on the top portion of each ridge. The metal layer may be present to cover the top portion of each ridge and further side faces of each ridge. In this case, the metal layer covering the top portion of each ridge and the metal layer covering side faces of the ridge are usually continuous. The metal layer may cover one of the side faces or both of the side faces. The metal layer covering side faces of each ridge may cover a portion of the ridge above a predetermined height of the ridge, or the metal layer may cover the entire surface of each side face. In a case where the metal layer does not cover surface of the light-transmitting substrate between the ridges but the metal layer covers the entire surface of each side face, there may be a slight protrusion of the metal layer of each side face from a portion where the surface of the light-transmitting substrate contacts with the side face of a ridge (rising portion of the ridge).

When the metal layer is present to cover the top portion of each ridge, it is possible to exhibit the function of the wire-grid polarizer. Moreover, when the metal layer is present to cover side faces of each ridge, s-polarized light incident from the rear surface of the light-transmitting substrate (a principal surface where no fine metallic wire is present) is absorbed, whereby the wire-grid polarizer shows a low s-polarized light reflectivity for light incident from the rear surface. Further, when the metal layer is present to cover the entire surface of each side face, s-polarized light incident from the front surface of the light-transmitting substrate is efficiently reflected, whereby the wire-grid polarizer shows a high polarization separation ability.

Further, when the metal layer is formed on a surface of the underlayer, it is possible to suppress generation of fine metallic particles caused by crystallization of the metallic material at a time of forming the metal layer. Accordingly, absorption of light due to the presence of fine metallic particles, is suppressed and the transmittance of the wire-grid polarizer is improved.

The height of the metal layer (the thickness in the height direction of ridge) on the top portion of each ridge is preferably at least 30 nm. When the height is at least 30 nm, transmission of s-polarized light (particularly in a short wavelength region) is suppressed, whereby the wire-grid polarizer shows a sufficiently high polarization separation ability. When the height of the metal layer on the top portion of each ridge is too high, diffraction phenomena or crystallization of the metal layer may occur to decrease the transmittance of the wire-grid polarizer, or formation of the metal layer may become difficult. Accordingly, the upper limit of the height of the metal layer is preferably 200 nm. The height of the metal layer on the top portion of each ridge is particularly preferably from 40 to 150 nm.

The height of the metal layer covering a side face of each ridge (thickness from a surface of the underlayer) is usually equal to or smaller than the height of the metal layer covering the top portion of each ridge. The thickness of the metal layer covering a side face of each ridge may gradually decrease from the top portion towards the bottom.

The metal layer covering each side face of each ridge is preferably present at least 50% of the side face of the ridge in terms of the area, more preferably at least 60%, further preferably at least 70%, particularly preferably 100%. Since the area of the metal layer covering each side face becomes large, s-polarized light incident from the rear surface of the wire-grid polarizer is efficiently absorbed, whereby the wire-grid polarizer shows a further low s-polarized light reflectivity for light incident from the rear surface. Further, when the metal layer occupies 100% of the area of each side face of each ridge, s-polarized light incident from the front surface of the light-transmitting substrate is efficiently reflected, whereby the wire-grid polarizer shows a high polarization separation ability.

The basic function of a wire-grid polarizer is determined by the width and the pitch (repeating distance in the width direction of fine metallic wires) of fine metallic wires. The width of each fine metallic wire (width in the direction perpendicular to the longitudinal direction of the fine metallic wire) is a width of the metal layer observed from the incident direction of light (a direction perpendicular to the principal surface of the light-transmitting substrate), which may be narrower or wider than the width of each ridge of the light-transmitting substrate. For example, when the top portion of each ridge is a plane, it is possible to form a metal layer having a width wider than the width of the top portion, and when the top portion of each ridge is a line, it is possible to form a metal layer having a certain width covering the top portion and side faces. When the top portion of each ridge is a plane, usually, the metal layer preferably has a width equal to or slightly wider than the width of the plane. Here, the pitch of the fine metallic wires is equal to the pitch of the ridges.

Provided that the width of each fine metallic wire is Da and the pitch is Pa, the ratio (Da/Pa) of Da to Pa is preferably from 0.1 to 0.6, more preferably from 0.2 to 0.5. When Da/Pa is at least 0.1, the wire-grid polarizer shows a further high degree of polarization for light incident from the front surface (a surface on which fine metallic layers are formed). When Da/Pa is at most 0.6, the p-polarized light transmittance further increases.

The pitch (Pa) is preferably at most 300 nm, more preferably from 50 to 200 nm. When Pa is at most 300 nm, the wire-grid polarizer shows a sufficiently high reflectivity and, in a short wavelength region in the vicinity of 400 nm, it shows a sufficiently high polarization separation ability. Further, a coloring phenomenon due to diffraction can be suppressed.

The width (Da) of each fine metallic wire is further preferably from 10 to 120 nm, and considering easiness of formation of the metal layer by vapor deposition, it is particularly preferably from 30 to 100 nm. Here, the maximum width of each ridge containing the underlayer is preferably equal to or less than the width (Da) of each fine metallic wire.

The material of the metal layer may be any material so long as it is a metal material having a sufficient electric conductivity, but it is preferably selected considering properties such as corrosion resistance besides the electric conductivity. As the metal material, a metal alone, an alloy or a metal containing a dopant or an impurity in an amount of at most a predetermined amount, may, for example, be mentioned. For example, aluminum, silver, chromium, magnesium, an aluminum type alloy or a silver type alloy may, for example, be mentioned. Further, a metal containing a non-metallic element such as carbon as a dopant, may also be used. From the viewpoint of high reflectivity for visible light, low absorption of visible light and high electric conductivity, the material is preferably aluminum, an aluminum type alloy, silver, chromium or magnesium, particularly preferably aluminum or an aluminum type alloy.

The metal layer is preferably formed by a vapor deposition method. As the vapor deposition method, a physical vapor deposition method (PVD) or a chemical vapor deposition method (CVD) are mentioned, and among these, a vapor deposition method such as a vacuum vapor deposition method, a sputtering method or an ion implanting method, is preferred. For formation of the metal layer, a vacuum vapor deposition method is particularly preferred. In the vacuum vapor deposition method, it is easy to control incident direction of adhering fine particles in relation to the light-transmitting substrate, and it is easy to carry out an oblique vapor deposition method to be described later. In the formation of the metal layer, since it is necessary to selectively vapor-deposit a metal to cover only the top portion of each ridge or to cover the top portion of each ridge and side faces of each ridge to form the metal layer, an oblique vapor deposition method using the vacuum vapor deposition method is the most preferable formation method of the metal layer. Further, among sputtering methods, a sputtering method (for example, a magnetron sputtering method) using a particularly high vacuum environment, can be used for formation of the metallic layer since it is relatively easy to control incident direction.

(PROTECTION LAYER)

Since the width and the thickness of each fine metallic wire is extremely small, even a slight scratch of the fine metallic wires adversely affects the performance of the wire-grid polarizer. Further, there is a case where the electric conductivity of the fine metallic wires is decreased by a chemical change (such as formation of rust) by e.g. oxidization, which deteriorates the performance of the wire-grid polarizer in some cases. Accordingly, in order to suppress e.g. scratch and chemical change, the fine metallic wires may be covered with a protection layer. The protection layer not only covers a surface of the metal layer, but it may cover an exposed surface of the underlayer (a surface on which no metal layer is formed) or an exposed surface of the light-transmitting substrate (a surface on which no underlayer is formed). Further, the protection layer may be formed so as to fill the grooves between the ridges to flatten a surface on which the fine metallic wires are to be formed.

As the material of the protection layer, a resin, a metal oxide or a glass may, for example, be mentioned. The material of a protection layer covering only the metal layer may be a non-light-transmitting opaque material, but the material of a protection layer covering also other surfaces needs to be a material that can form a light-transmitting protection layer. Even when the light-transmittance of the material itself is low, it is possible to form a light-transmitting protection layer if the thickness of the layer is sufficiently thin. Further, the material of the protection layer is preferably a material having a high thermal resistance and chemical resistance. Here, it is also possible to naturally or positively cause a chemical change of a surface of the metal layer to form a protection layer. For example, in a case of employing aluminum as the material of the metal layer, aluminum is oxidized in the air to form an aluminum oxide thin film on the surface, and the metal oxide thin film functions as a protection layer of the fine metallic wires.

When the protection layer covers also a surface of the underlayer or a surface of the light-transmitting substrate, an interface between the protection layer and these surfaces may reduce p-polarized light reflectivity. For this reason, it is preferred to make the reflectivity of the protection layer and the reflectivity of the underlayer or the light-transmitting substrate be substantially equal. Further, from the viewpoint of obtaining a high polarization separation ability in a wide wavelength range, the protection layer is preferably made of a material having a low refractive index.

Since the protection layer is present on the outermost surface of the wire-grid polarizer, the protection layer preferably has a pencil hardness of at least H, and preferably has also an anti-pollution property. Further, an antireflective structure (such as an antireflective film) may be provided on a surface of the protection layer. Here, a hard surface layer or an antireflective structure may be provided also on the rear surface of the light-transmitting substrate.

<PROCESS FOR PRODUCING A WIRE-GRID POLARIZER>

The wire-grid polarizer is produced by preparing a light-transmitting substrate having a surface on which a plurality of ridges are formed in parallel with one another at a predetermined pitch, forming the underlayer and subsequently forming the metal layer.

(PREPARATION OF LIGHT-TRANSMITTING SUBSTRATE)

The process for producing the light-transmitting substrate may, for example, be an imprinting method (photoimprinting method or thermoimprinting method) or a lithography method. From the viewpoint of productivity in forming the ridges and capability of producing a light-transmitting substrate having a large area, the process is preferably an imprinting method, and from the viewpoint of high productivity in producing the ridges and capability of transferring the shape of grooves of a mold with high precision, the process is particularly preferably a photoimprinting method.

The photoimprinting method is, for example, be a method of preparing a mold in which a plurality of grooves are formed in parallel with one another at a predetermined pitch by a combination of electron beam lithography and etching, transferring the shape of the grooves of the mold into a photocurable composition applied on a surface of an optional substratum, and photocuring the photocurable composition at the same time.

The preparation of light-transmitting substrate by the photoimprinting method is preferably specifically carried out through the following steps (i) to (iv).

(i) A step of applying a photocurable composition on a surface of a substratum.

(ii) A step of pressing a mold in which a plurality of grooves are formed so as to be parallel with one another at a predetermined pitch, against the photocurable composition so that the grooves contact with the photocurable composition.

(iii) A step of radiating a radiation (UV rays, electron beams, etc.) to the mold in a state that the mold is pressed against the photocurable composition, to cure the photocurable composition to produce a light-transmitting substrate having a plurality of ridges corresponding to the grooves of the mold.
(iv) A step of separating the mold from the light-transmitting substrate.

Here, on the obtained light-transmitting substrate on the substratum, it is possible to form the underlayer and the metal layer to be described later while the substrate is integrally combined with the substratum. Further, as the case requires, the light-transmitting substrate and the substratum may be separated after formation of the metal layer. Further, it is possible to form the underlayer and the metal layer to be described later, after the light-transmitting substrate formed on the substratum is separated from the substratum.

The preparation of light-transmitting substrate by a thermoimprinting method is preferably specifically carried out through the following steps (i) to (iii).

(i) A step of forming on a surface of a substratum a layer of thermoplastic resin to which a pattern is to be transferred, or a step of producing a film of thermoplastic resin to which a pattern is to be transferred.
(ii) A step of pressing a mold in which a plurality of grooves are formed so as to be parallel with one another at a predetermined pitch, against the layer to be transferred or the film to be transferred, so that the grooves contact with the layer to be transferred or the film to be transferred, in a state that they are heated to be at least the glass transition temperature (Tg) or the melting point (Tm) of the thermoplastic resin, to prepare a light-transmitting substrate having a plurality of ridges corresponding to the grooves of the mold.
(iii) A step of cooling the light-transmitting substrate to a temperature lower than Tg or Tm and separating the mold from the light-transmitting substrate.

Here, on the obtained light-transmitting substrate on the substratum, it is possible to form the underlayer and the metal layer to be described later while the substrate is integrally combined with the substratum. Further, as the case requires, the light-transmitting substrate and the substratum may be separated after formation of the metal layer. Further, it is possible to form the underlayer and the metal layer to be described later, after the light-transmitting substrate formed on the substratum is separated from the substratum.

(FORMATION OF UNDERLAYER AND METAL LAYER)

The wire-grid polarizer of the present invention is preferably produced by a process comprising: vapor-depositing a metal oxide at least on the top portion of each of a plurality of ridges formed in parallel with one another at a predetermined pitch on a surface of a light-transmitting substrate, to form an underlayer made of the metal oxide; and vapor-depositing a metal on a surface of the underlayer so as to cover at least the top portion of each ridge to form a metal layer to form a fine metallic wire. As described above, the underlayer is preferably formed on at least the top portion of each ridge by an oblique vapor deposition method using a vapor deposition method. Further, in a case of forming the underlayer on the entire surface of each ridge and each surface of the light-transmitting substrate between the ridges, the underlayer is preferably formed by a sputtering method. The metal layer is preferably formed to cover at least a part of each side face of each ridge and the top portion of each ridge, more preferably formed to cover the entire surface of each side face and the top portion of each ridge. In order to thus selectively form the metal layer on particular surfaces, the metal layer is preferably formed by an oblique vapor deposition method using a vacuum vapor deposition method.

In the formation of the underlayer or the metal layer by an oblique vapor deposition method, a step of vapor deposition from a direction substantially perpendicular to the longitudinal direction of each ridge and at a certain angle to the height direction of each ridge, and a step of vapor deposition from a direction substantially perpendicular to the longitudinal direction of each ridge and at a certain angle to the height direction of each ridge from a side opposite to the above angle, are alternately carried out at least once to form the objective underlayer or metal layer. Here, in this specification, "substantially perpendicular" means at an angle within a range of from 85 to 95° to the longitudinal direction of each ridge or the height direction of each ridge.

Using formation of the metal layer by an oblique vapor deposition method as an example, the oblique vapor deposition method is further described. Formation of the metal layer is preferably carried out under the following conditions. This method is suitable for a case of producing a wire-grid polarizer of the third embodiment to be described later.

(A) the metal is vapor-deposited from a direction substantially perpendicular to the longitudinal direction of each ridge and at an angle of $\theta^R$ to the height direction of the ridge;
(B) the metal is vapor-deposited from a direction substantially perpendicular to the longitudinal direction of the ridge and at an angle of $\theta^L$ on the opposite side from the angle $\theta^R$ to the height direction;
(C) a vapor deposition under the above condition (A) and a vapor deposition under the above condition (B) are carried out alternately so that the number of vapor depositions under the above condition (A) is m (wherein m is at least 1) and the number of vapor depositions under the condition (B) is n (wherein n is at least 1), and the total (m+n) becomes at least 3;

(D) the angle $\theta^R$ in the first vapor deposition in the m times of vapor depositions under the above condition (A) satisfies the following formula (IV) and the angle $\theta^L$ in the first vapor deposition in the n times of vapor depositions under the above condition (B) satisfies the following formula (V):

$$15° \leqq \theta^R \leqq 45° \qquad \text{(IV)},$$

and

$$15° \leqq \theta^L \leqq 45° \qquad \text{(V)};$$

and

(E) when the above m is at least 2, the angle $\theta^R_i$ in the m-th time (wherein i is from 2 to m) and $\theta^R_{(i-1)}$ in the (i-1)-th time satisfy the following formula (VI), and when the above n is at least 2, the angle $\theta^L_j$ in the j-th time (wherein j is from 2 to i) satisfy the following formula (VII):

$$\theta^R_i \leqq \theta^R_{(i-1)} \qquad \text{(VI)},$$

and

$$\theta^L_j \leqq \theta^L_{(j-1)} \qquad \text{(IV)}.$$

In a case of producing a wire-grid polarizer of the first or the second embodiment to be described later, it is possible to form the metal layer in the same manner by changing the direction of vapor deposition or the number of vapor depositions in the above conditions. For example, in the first embodiment, it is possible to reduce the vapor deposition angle in the condition of (D), and in the second embodiment, it is possible to set the vapor deposition angles on both directions at respective first vapor depositions to be large vapor deposition angles, and to make second and subsequent vapor deposition angles to be at most 40° in the same manner as above.

In a case of forming the underlayer by an oblique vapor deposition method, it is necessary form the underlayer on at least an area where the metal layer is to be formed. In order to form the underlayer on the top portion of each ridge or on each surface of the light-transmitting substrate between the ridges, it is preferred to use an angle smaller than 15°. In the case of oblique vapor deposition method, since vapor deposition in the perpendicular direction occurs to a certain extent even if the vapor deposition angle is large, it is usually preferred to use a large vapor deposition angle. Accordingly, in a case of forming the underlayer by an oblique vapor deposition method, an angle larger than 45° is used for each of angle $\theta^R$ and angle $\theta^L$, and an appropriate angle is at least 60° and less than 90°. The angle is preferably from 65 to 85°, more preferably from 70 to 80°. Here, in the case of forming the underlayer by an oblique vapor deposition method, the above (m+n) may be 2, and the above condition (D) is not essential.

In a sputtering method, the vapor deposition direction is random, and in the case of forming the underlayer, it is possible to form an underlayer having a substantially uniform thickness on a surface of the light-transmitting substrate regardless of its waviness, by employing the sputtering method. Accordingly, formation of the underlayer is more preferably carried out by a sputtering method.

<WIRE-GRID POLARIZER OF EACH EMBODIMENT>

Wire-grid polarizers of the present invention are described below with reference to drawings. The drawings are schematic views, and an actual wire-grid polarizer does not have the logical and ideal shape as shown in these drawings. For example, there is a considerable degree of deformation in the shape of e.g. each ridge and there is also a considerable amount of unevenness of the thickness of the underlayer or the metal layer. The ridges on surfaces of the light-transmitting substrates in these drawings each has a rectangular cross-section, but as described above, in an actually produced wire-grid polarizer, each ridge often has a shape in which the top portion is rounded or the width narrows towards the top.

[FIRST EMBODIMENT]

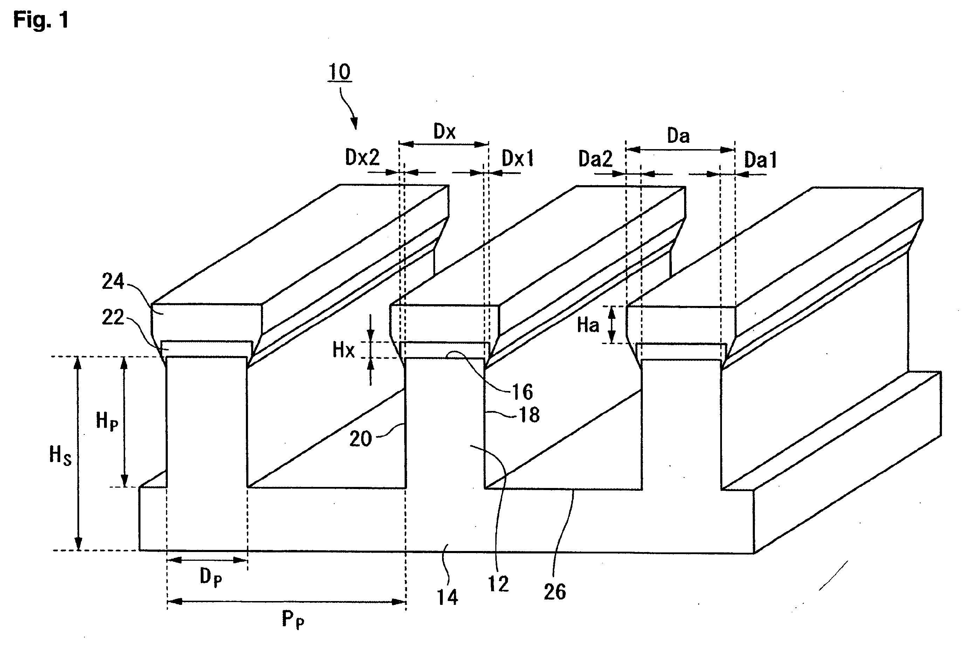

Fig. 1 is a perspective view showing a first embodiment of the wire-grid polarizer of the present invention. A wire-grid polarizer 10 has a light-transmitting substrate 14 having a surface on which a plurality of ridges 12 are formed in parallel with one another at a predetermined pitch (Pp); an underlayer 22 covering the top face 16 of each ridge 12 and upper end portions of side faces 18 and 20 that are two side faces extending in the longitudinal direction of the ridge 12; and a metal layer 24 made of a metal and formed on an upper surface of the underlayer 22. The metal layer 22 extends in the longitudinal direction of each ridge to form a fine metallic wire. Hereinafter, a surface of the light-transmitting substrate between the ridges is referred to as a groove 26.

Pp is a sum total of a width Pp of each ridge 12 and the width of each groove 26 formed between the ridges 12. Pp is preferably from 50 to 200 nm.

The ratio (Dp/Pp) of Dp to Pp is preferably from 0.1 to 0.55, preferably from 0.25 to 0.45.

Further, Dp is preferably from 30 to 80 nm from the viewpoint of easiness of formation of the metal layer by vapor deposition.

The height Hp of the ridge 12 is preferably from 50 to 300 nm.

The thickness Hs of the light-transmitting substrate 14 is preferably from 1 to 40 $\mu$m.

The height Hx of the underlayer 22 on the top portion of each ridge is the thickness of the underlayer in its portion covering the top face 16 of the ridge 12. Hx is preferably from 2 to 15 nm.

Dx1 and Dx2 in the first embodiment are widths of portions of the underlayer 22 projecting outwardly from the side face 18 and the side face 20, respectively, of the ridge 12, and Da1 and Da2 are widths of portions of the metal layer 24 projecting outwardly from the side face 18 and the side face 20, respectively, of the ridge 12.

The width Da of the metal layer 24, the pitch Pp of the ridge 12 and the width Dp of the ridge 12 preferably satisfy the following formula (5):

$$Da\text{-}Dp \leq 0.4 \times (Pp\text{-}Dp) \qquad (5).$$

When Da-Dp is at most $0.4\times$(Pp-Dp), an opening of each groove 26 is maintained, whereby the p-polarized light transmittance of the wire-grid polarizer 10 improves.

[SECOND EMBODIMENT]

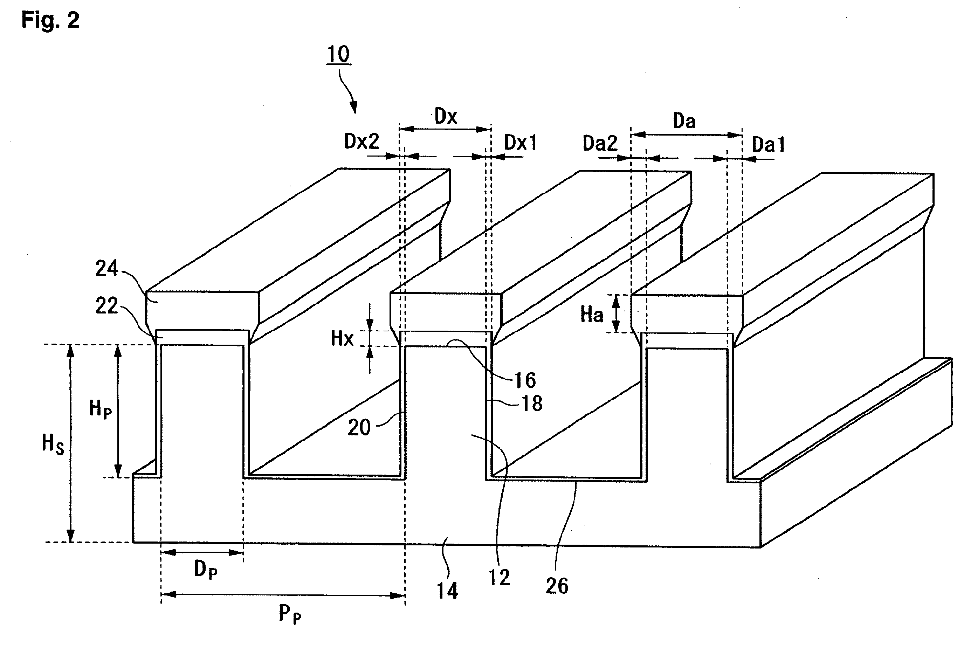

Fig. 2 is a perspective view showing a first embodiment of the wire-grid polarizer of the present invention. A wire-grid polarizer 10 has a light-transmitting substrate 14 having a surface on which a plurality of ridges 12 are formed in parallel with one another at a predetermined pitch (Pp); an underlayer 22 covering the top face 16 of each ridge 12, upper end portions of side faces 18 and 20 that are two side faces extending in the longitudinal direction of the ridge 12, and the bottom face of each groove 26; and a metal layer 24 made of a metal and formed on an upper surface of the underlayer 22.

In the second embodiment, explanation of the same constructions of those of the wire-grid polarizer 10 of the first embodiment is omitted.

Dx1 and Dx2 of the second embodiment are widths of portions of the underlayer 22 projecting outwardly from the side face 18 and the side face 20, respectively, of the ridge 12, and they are also the thicknesses of the underlayer 22 covering the side face 18 and the side face 20, respectively, of the ridge 12.

[THIRD EMBODIMENT]

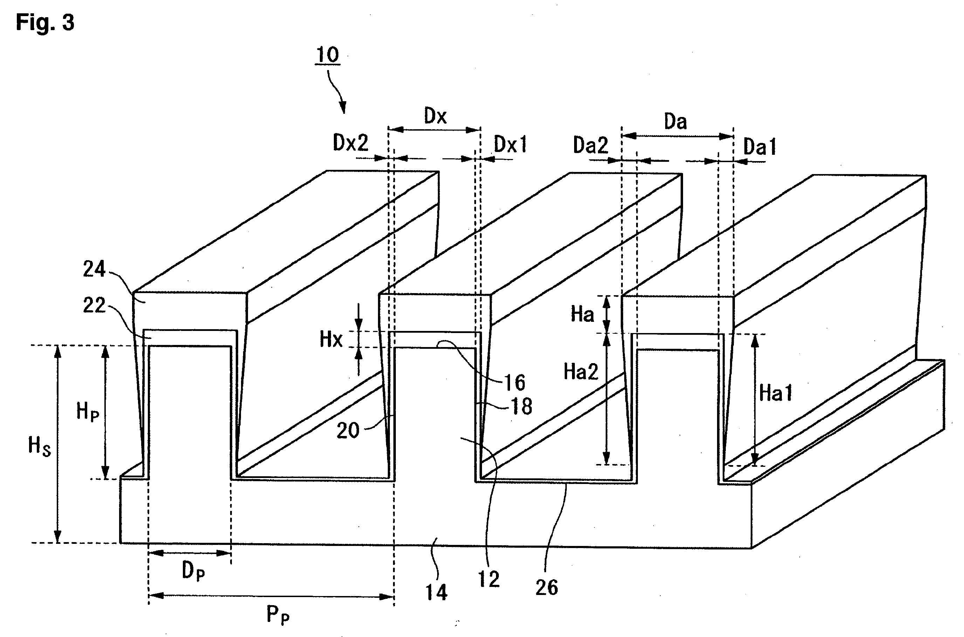

Fig. 3 is a perspective view showing a third embodiment of the wire-grid polarizer of the present invention. A wire-grid polarizer 10 has a light-transmitting substrate 14 having a surface on which a plurality of ridges 12 are formed in parallel with one another at a predetermined pitch (Pp); an underlayer 22 covering the top face 16 of each ridge 12, a side face 18 and a side face 20, that are two side faces extending in the longitudinal direction of the ridge 12, and the bottom face of each groove 26; and a metal layer 24 covering the top face 16, the side face 18 and the side face 20 of each ridge 12.

In the third embodiment, explanation of the same constructions of those of the wire-grid polarizer 10 of the first embodiment or the second embodiment is omitted.

Da1 and Da2 in the third embodiment are widths of portions of the metal layer 24 projecting outwardly from the side face 18 and the side face 20, respectively, of each ridge 12, and they are also the thicknesses of the metal layer 24 formed on the underlayer 22 covering the side face 18 and the side face 20, respectively, of each ridge 12.

The width Ha1 (length in the depth direction from the top face 16 of a ridge 12 to a groove) of the metal layer 24 covering the side face 18 of the ridge 12; the width Ha2 (length in the depth direction from the top face 16 of a ridge 12 to a groove) of the metal layer 24 covering the side face 20 of the ridge 12, and the height Hp of the ridge 12 preferably satisfy the following formulae (6-1) and (7-1), more preferably satisfy the following formulae (6-2) and (7-2), further preferably satisfy the following formulae (6-3) and (7-3):

$$Ha1 \geq 0.5 \times Hp \qquad (6\text{-}1)$$

$$Ha2 \geq 0.5 \times Hp \qquad (7\text{-}1)$$

$$Ha1 \geq 0.6 \times Hp \qquad (6\text{-}2)$$

$$Ha2 \geq 0.6 \times Hp \qquad (7\text{-}2)$$

$$Ha1 = Hp \qquad (6\text{-}3)$$

$$Ha2 = Hp \qquad (7\text{-}3)$$

When Ha1 and Ha2 are each at least 50% of Hp, the area of the metal layer 24 covering the side face 18 and the area of the metal layer 24 covering the side face 20 become large, and s-polarized light incident from a rear surface of the wire-grid polarizer 10 is efficiently absorbed, whereby the wire-grid polarizer 10 shows a further low s-polarized light reflectivity for light incident from the rear surface. When Ha1 and Ha2 equal to Hp, s-polarized light incident from a front surface of the wire-grid polarizer 10 is efficiently reflected, whereby the wire-grid polarizer 10 shows a high polarization separation ability.

Here, the top face 16, the side face 18 and the side face 20 of each ridge 12, and the bottom face of each groove 26 may be each a plane or a curved face.

<PROCESS FOR PRODUCING WIRE-GRID POLARIZER OF EACH EMBODIMENT>

[PROCESS FOR PRODUCING WIRE-GRID POLARIZER OF FIRST EMBODIMENT]

The wire-grid polarizer 10 of the first embodiment can be produced by a process of forming the underlayer 22 covering the top face 16 of each ridge 12 of the light-transmitting substrate 14, and the metal layer 24 formed on the underlayer 22, by a vapor deposition method satisfying the following conditions (A1) to (J1).

(PROCESS FOR FORMING UNDERLAYER)

The underlayer 22 is formed by an oblique vapor deposition method of vapor-depositing a metal oxide from an obliquely upward direction to a face of the light-transmitting substrate 14 on which the ridges 12 are formed.

The underlayer 22 is specifically preferably formed by an oblique vapor deposition method satisfying the following conditions (A1) to (E1).

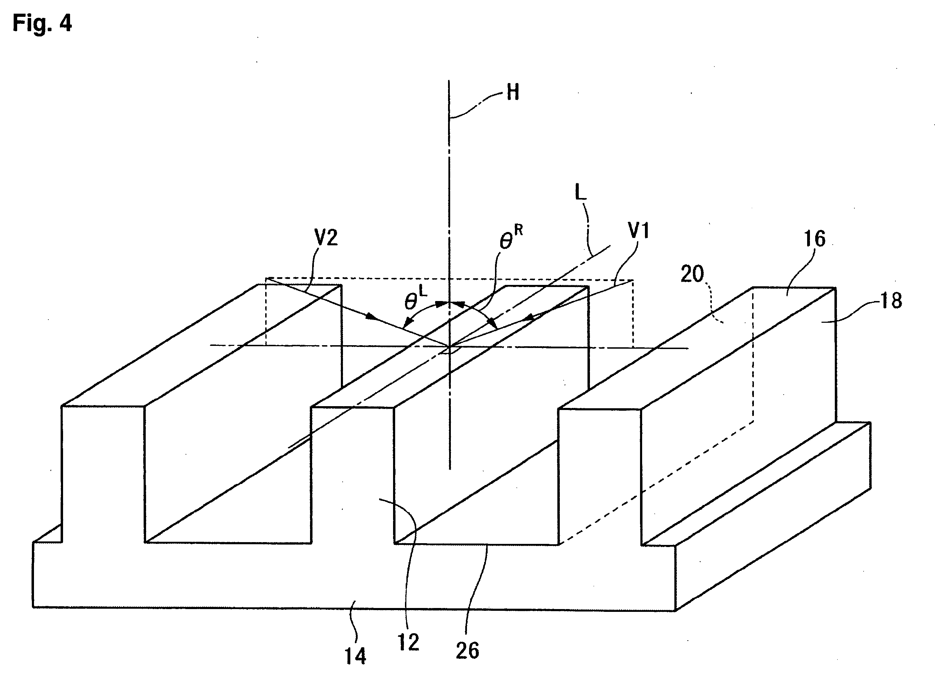

(A1) As shown in Fig. 4, a metal oxide is vapor-deposited on the top face 16 of each ridge 12 or on a top face of an underlayer 22 formed by vapor deposition under the following condition (B1) from a direction V1 substantially perpendicular to the longitudinal direction L of each ridge 12 and at an angle of $\theta^R$ on the side face 18 side to the height direction H of each ridge 12.

(B1) As shown in Fig. 4, a metal oxide is vapor-deposited on the top face 16 of each ridge 12 or on a top face of an underlayer 22 formed by vapor deposition under the above condition (A1) from a direction V2 substantially perpendicular to the longitudinal direction L of each ridge 12 and at an angle of $\theta^L$ on the side face 20 side to the height direction H of each ridge 12.

(C1) Vapor deposition under the above condition (A1) is carried out once and vapor deposition under the above condition (B1) is carried out once.

(D1) The angle $\theta^R$ in the vapor deposition under the above condition (A1) preferably satisfies the following formula (1-I), and the angle $\theta^L$ in the vapor deposition under the above condition (B1) preferably satisfies the following formula (1-II):

$$45° \leq \theta^R < 90° \qquad (1\text{-}I)$$

and

$$45° \leq \theta^L < 90° \qquad (1\text{-}II).$$

(E1) The height of the underlayer 22 formed by the vapor deposition under the above condition (A1) and the height of the underlayer 22 formed by the vapor deposition under the above condition (B1) preferably satisfy the following formula (1-III):

$$0.5 \text{ nm} \leq Hx' \leq 15 \text{ nm} \qquad (1\text{-}III).$$

Here, Hx' is the height of the underlayer 22 on the top portion of each ridge formed by each vapor deposition.

Conditions (A1) to (C1): If the conditions (A1) to (C1) are not satisfied, since a portion of the underlayer 22 projecting outwardly from the side face 18 or the side face 20 of the ridge 12 is not formed, a metal tends to be vapor deposited on the side face 18 and the side face 20 at a time of forming the metal layer 24. Further, a metal oxide tends to be vapor-deposited on the bottom face of each groove 26.

Condition (D1): In a case of carrying out a vapor deposition on ridges 12 having a pitch of the wavelength of light or smaller, since the shape of the underlayer 22 changes according to the angle $\theta^R$ (or $\theta^L$) of the vapor deposition, an underlayer 22 having an appropriate shape may not be formed at some angle $\theta^R$ (or $\theta^L$). Further, if the angle $\theta^R$ (or $\theta^L$) is less than 45°, a portion of the underlayer 22 projecting outwardly from the side face 18 or the side face 20 is not formed. Or their widths Dx1 and Dx2 become insufficient. Or at a time of forming portions of the underlayer 22 projecting outwardly from the side face 18 or the side face 20, a metal oxide is vapor deposited on the side face 18 and the side face 20. If the angle $\theta^R$ (or $\theta^L$) is 90°, formation of the underlayer 22 is difficult. Accordingly, in a case of forming an underlayer having a width wider than the top face 16 of each ridge 12 as shown in Fig. 1, the angle $\theta^R$ (or $\theta^L$) is preferably from 65 to 85°.

Condition (E1): If the height Hx' of the underlayer 22 formed by each vapor deposition is less than 0.5 $\mu$m, a portion of the underlayer 22 projecting outwardly from the side face 18 or the side face 20 of each ridge 12 is not sufficiently formed, and accordingly, metal tends to be formed on the side face 18 and the side face 20 at a time of forming the metal layer 24. If Hx' exceeds 10 nm, the thickness of the underlayer 22 becomes large, and accordingly, the wavelength dispersion of the wire-grid polarizer 10 increases, and the transmittance in a short wavelength side decreases. Hx' is preferably from 2 to 10 nm.

(PROCESS FOR FORMING METAL LAYER)

The metal layer 24 is formed by vapor-depositing a metal from an oblique upper side to a face of the light-transmitting substrate 14 on which ridges are formed.

The metal layer 24 is specifically preferably formed by an oblique vapor deposition method satisfying the following conditions (F1) to (J1).

(F1) A metal is vapor-deposited on the top face of the underlayer 22 or the top face of the metal layer 24 formed by vapor deposition under the following condition (G1) from a direction V1 substantially perpendicular to the longitudinal direction L of each ridge 12 and at an angle of $\theta^R$ on the side face 18 side to the height direction H of each ridge 12.
(G1) A metal is vapor-deposited on the top face of the underlayer 22 or the top face of the metal layer 24 formed by vapor deposition under the above condition (F1) from a direction V2 substantially perpendicular to the longitudinal direction L of each ridge 12 and at an angle of $\theta^L$ on the side face 20 side to the height direction H of each ridge 12.
(H1) Vapor deposition under the above condition (F1) and vapor deposition under the above condition (G1) are carried out alternately so that the number of the vapor depositions under the above condition (F1) is m (m is at least 1) and the number of vapor depositions under the above condition (G1) is n (n is at least 1) and the total (m+n) is at least 3.

(I1) The angle $\theta^R$ at the first vapor deposition among m times of the vapor depositions under the above condition (F1) satisfies the following formula (1-IV), and the angle $\theta^L$ at the first vapor deposition among n times of the vapor depositions under the above condition (G1) satisfies the following formula (1-V):

$$10° \leqq \theta^R \leqq 45° \qquad \text{(1-IV)}$$

and

$$10° \leqq \theta^L \leqq 45° \qquad \text{(1-V)}.$$

(J1) When the above m is at least 2, $\theta^R_i$ of i-th time (i=2 to m) and $\theta^R_{(i-1)}$ of (i-1)-th time satisfy the following formula (1-VI), and when the above n is at least 2, $\theta^L_j$ of j-th time (j=2 to n) and $\theta^L_{(j-1)}$ of (j-1)-th time satisfy the following formula (1-VII):

$$\theta^R_i \leqq \theta^R_{(i-1)} \qquad \text{(1-VI)},$$

and

$$\theta^L_j \leqq \theta^L_{(j-1)} \qquad \text{(1-VII)}.$$

Conditions (F1) and (G1): If the conditions (F1) and (G1) are not satisfied, a metal tends to be vapor deposited on the bottom face of each groove 26.

Condition (H1): Vapor deposition under the condition (F1) and vapor deposition under the condition (G1) are carried out alternately at least 3 times in total, a uniform metal layer 24 is formed without causing uneven vapor deposition of the metal.

Condition (I1): At a time of carrying out vapor deposition to cover ridges 12 having a pitch of the wavelength of light or smaller, since the shape of the metal layer 24 changes depending on the angle $\theta^R$ (or $\theta^L$) of the vapor deposition, there is a case where a metal layer 24 having an appropriate shape cannot be formed under some angle $\theta^R$ (or $\theta^L$) conditions. If the angle $\theta^R$ at the first vapor deposition among m times of the vapor depositions and the angle $\theta^L$ at the first vapor deposition among n times of the vapor depositions are each less than 10°, a metal is vapor-deposited also on the bottom face of each groove 26 between the ridges 12. If the angle $\theta^R$ at the first vapor deposition among m times of the vapor depositions and the angle $\theta^L$ at the first vapor deposition among n times of the vapor depositions each exceed 45°, the metal is unevenly vapor-deposited, whereby an obliquely inclined metal layer 24 is formed.

Condition (J1): If the condition (J1) is not satisfied, it is difficult to form a metal layer 24 having a height Ha of at least 30 nm is difficult.

[PROCESS FOR PRODUCING WIRE-GRID POLARIZER OF SECOND EMBODIMENT]

A wire-grid polarizer 10 of the second embodiment can be produced by a process of forming the underlayer 22 covering the top face 16, the side face 18 and the side face 20 of each ridge of the light-transmitting substrate 14 and the bottom face of each groove 26, by a sputtering method, and forming the metal layer 24 on the top face of the underlayer 22 covering the top face 16 of each ridge 12, by a vapor deposition method satisfying the following conditions (A2) to (H2).

(PROCESS FOR FORMING UNDERLAYER)

The underlayer 22 is formed by a sputtering method of making a metal oxide adhere to the entire surface of a face of the light-transmitting substrate 14 on which the ridges 12 are formed.

(PROCESS FOR FORMING METAL LAYER)

The metal layer 24 is formed by vapor-depositing a metal from an oblique upward direction to a face of the light-transmitting substrate 14 on which the ridges 12 are formed. Since an underlayer 22 formed by a sputtering method does not have a portion sufficiently projecting outwardly from the side face 18 or the side face 20 of each ridge 12, a metal tends to be vapor-deposited on the side face 18 and the side face 20 at a time of forming the metal layer 24. Accordingly, in order to avoid formation of the metal layer 24 on the side faces, and to form the metal layer 24 having a width wider than the top face 16 of each ridge 12, the metal layer is preferably specifically formed by an oblique vapor deposition method satisfying the following conditions (A2) to (H2).

(A2) As shown in Fig. 4, a metal is vapor-deposited at least once on a surface of the underlayer 22 and/or a surface of the metal layer 24 formed by vapor deposition under the following condition (B2) from a direction V1 substantially perpendicular to the longitudinal direction L of each ridge 12 and at an angle of $\theta^R$ on the side face 18 side to the height direction H of each ridge 12.

(B2) As shown in Fig. 4, a metal is vapor-deposited at least once on a surface of the underlayer 22 and/or a surface of the metal layer 24 formed by vapor deposition under the above condition (A2) from a direction V2 substantially perpendicular to the longitudinal direction L of each ridge 12 and at an angle of $\theta^L$ on the side face 20 side to the height direction H of each ridge 12.

(C2) Vapor deposition under the above condition (A2) and the vapor deposition under the above condition (B2) are carried out alternately so that the number of vapor depositions under the above condition (A2) is m (m is at least 2) and the number of vapor depositions under the condition (B2) is n (n is at least 2) and the total (m+n) becomes at least 5.

(D2) The angle $\theta^R$ at the first vapor deposition among m times of the vapor depositions under the above condition (A2) satisfies the following formula (2-I), and the angle $\theta^L$ at the first vapor deposition among n times of the vapor depositions under the above condition (B2) satisfies the following formula (2-II):

$$45° \leq \theta^R < 90° \qquad (2\text{-}I)$$

and

$$45° \leq \theta^L < 90° \qquad (2\text{-}II).$$

(E2) The height of the metal layer 24 formed by the first vapor deposition among m times of the vapor depositions under the above condition (A2) and the height of the metal layer 24 formed by the first vapor deposition among n times of the vapor depositions under the above condition (B2) satisfy the following formula (2-III).

$$0.5 \text{ nm} \leq Ha' \leq 10 \text{ nm} \qquad (2\text{-}III).$$

Here, Ha' is the height of the metal layer 24 formed by each vapor deposition.

(F2) The angle $\theta^R$ at the second vapor deposition among m times of the vapor depositions under the above condition (A2) satisfies the following formula (2-IV), and the angle $\theta^L$ at the second vapor deposition among n times of the vapor depositions under the above condition (B2) satisfies the following formula (2-V):

$$10° \leq \theta^R \leq 45° \qquad (2\text{-}IV)$$

and

$$10° \leq \theta^L \leq 45° \qquad (2\text{-}V).$$

(G2) The height of the metal layer 24 formed by the second vapor deposition among m times of the vapor depositions under the above condition (A2) and the height of the metal layer 24 formed by the second vapor deposition among n times of the vapor depositions under the above condition (B2) satisfy the following formula (2-III).

$$1 \text{ nm} \leq \text{Ha'} \leq 15 \text{ nm} \qquad \text{(2-III).}$$

Here, Ha' is the height of the metal layer 24 formed by each vapor deposition.

(H2) When the above m is at least 3, $\theta^R_i$ of i-th time (i=3 to m) and $\theta^R_{(i-1)}$ of (i-1)-th time satisfy the following formula (2-VI), and when the above n is at least 3, $\theta^L_j$ of j-th time (j=3 to n) and $\theta^L_{(j-1)}$ of (j-1)-th time satisfy the following formula (2-VII):

$$\theta^R_i \leq \theta^R_{(i-1)} \qquad \text{(2-VI),}$$

and

$$\theta^L_j \leq \theta^L_{(j-1)} \qquad \text{(2-VII).}$$

Conditions (A2) and (B2): If the conditions (A2) and (B2) are not satisfied, since a portion of the metal layer 24 projecting outwardly from the side face 18 or the side face of 20 of each ridge 12 are not formed, a metal tends to be vapor-deposited on the underlayer 22 covering the side face 18 and the side face 20. Further, the metal tends to be vapor-deposited on the bottom face of each groove 26.

Condition (C2): Vapor deposition under the condition (A2) and vapor deposition under the condition (B2) are carried out alternately so that the number of vapor depositions become at least 5 in total, whereby the metal is vapor deposited without unevenness and a uniform metal layer 24 is formed.

Condition (D2): At a time of carrying out vapor deposition on ridges 12 having a pitch of the wavelength of light or smaller, since the shape of the metal layer 24 changes depending on the angle $\theta^R$ (or $\theta^L$) of the vapor deposition, there is a case where a metal layer 24 having an appropriate shape cannot be formed under some angle $\theta^R$ (or $\theta^L$) conditions. If the angle $\theta^R$ (or $\theta^L$) is less than 45°, a portion of the metal layer 24 projecting outwardly from the side face 18 or the side face 20 of each ridge 12 is not formed. Or their widths Da1 and Da2 become insufficient. Or at a time of forming a portion of the metal layer 24 projecting outwardly from the side face 18 or the side face 20 of each ridge 12, a metal is vapor deposited on the underlayer 22 covering the side face 18 and the side face 20. If the angle $\theta^R$ (or $\theta^L$) is 90°, formation of the metal layer 24 is difficult. The angle $\theta^R$ (or $\theta^L$) is preferably at least 60° and at most 85°, particularly preferably from 65° to 80°.

Condition (E2): If the height Ha' of the metal layer 24 on the top portion of each ridge 12 formed by each vapor deposition is less than 0.5 nm, a portion of the metal layer 24 projecting outwardly from the side face 18 or the side face 20 of each ridge 12 is not sufficiently formed, whereby the metal tends to be vapor-deposited on the underlayer 22 covering the side face 18 and the side face 20. If Ha' exceeds 10 nm, the thickness of the metal layer 24 becomes too large.

Condition (F2): At a time of carrying out vapor deposition to cover ridges 12 having a pitch of the wavelength of light or smaller, since the shape of the metal layer 24 changes depending on the angle $\theta^R$ (or $\theta^L$) of the vapor deposition, there is a case where a metal layer 24 having an appropriate shape cannot be formed under some angle $\theta^R$ (or $\theta^L$) conditions. If the angle $\theta^R$ at the second vapor deposition among m times of the vapor depositions and the angle $\theta^L$ at the second vapor deposition among n times of the vapor depositions are each less than 10°, a metal is vapor-deposited also on the bottom face of each groove 26 between the ridges 12. If the angle $\theta^R$ at the second vapor deposition among m times of the vapor depositions and the angle $\theta^L$ at the second vapor deposition among n times of the vapor depositions each exceed 45°, the metal is unevenly vapor-deposited, whereby an obliquely inclined metal layer 24 is formed.

Condition (G2): If the height Ha' of the metal layer 24 formed by each vapor deposition is less than 1 nm, it is difficult to form a metal layer 24 having a height Ha of at least 30 nm. If Ha' exceeds 15 nm, the thickness of the metal layer 24 becomes large.

Condition (H2): If the condition (H2) is not satisfied, it is difficult to form a metal layer 24 having a height Ha of at least 30 nm.

[PROCESS FOR PRODUCING WIRE-GRID POLARIZER OF THIRD EMBODIMENT]

A wire-grid polarizer 10 of the third embodiment is preferably formed by a process of forming the underlayer 22 covering the top face 16, the side face 18 and the side face 20 of each ridge 12 of the light-transmitting substrate 14 and the bottom face of each groove 26, by a sputtering method, and forming the metal layer 24 on a surface of the underlayer 22 covering the top face 16, the side face 18 and the side face 20 of each ridge 12, by an oblique vapor deposition method satisfying the following conditions (A3) to (E3).

(PROCESS FOR FORMING UNDERLAYER)

The underlayer 22 is formed by a sputtering method of making a metal oxide adhere to the entire surface of a plane of the light-transmitting substrate 14 on which the ridges 12 are formed.

(PROCESS FOR FORMING METAL LAYER)

The metal layer 24 is formed by vapor-depositing a metal from an oblique upward direction to a face of the light-transmitting substrate 14 on which the ridges 12 are formed.
The metal layer 24 is specifically formed by an oblique vapor deposition method satisfying the following conditions (A3) to (E3).

(A3) As shown in Fig. 4, a metal is vapor-deposited at least once on a surface of the underlayer 22 and/or a surface of the metal layer 24 formed by vapor deposition under the following condition (B3) from a direction V1 substantially perpendicular to the longitudinal direction L of each ridge 12 and at an angle of $\theta^R$ on the side face 18 side to the height direction H of each ridge 12.

(B3) As shown in Fig. 4, a metal is vapor-deposited at least once on a surface of the underlayer 22 and/or a surface of the metal layer 24 formed by vapor deposition under the above condition (A3) from a direction V2 substantially perpendicular to the longitudinal direction L of each ridge 12 and at an angle of $\theta^L$ on the side face 20 side to the height direction H of each ridge 12.

(C3) Vapor deposition under the above condition (A3) and the vapor deposition under the above condition (B3) are alternately carried out so that the number of vapor depositions under the above condition (A3) is m (m is at least 1) and the number of vapor depositions under the condition (B3) is n (n is at least 1) and the total (m+n) becomes at least 3, preferably at most 6, more preferably from 4 to 5.

(D3) The angle $\theta^R$ at the first vapor deposition among m times of the vapor depositions under the above condition (A3) satisfies the following formula (3-IV), and the angle $\theta^L$ at the first vapor deposition among n times of the vapor depositions under the above condition (B3) satisfies the following formula (3-V):

$$15° \leqq \theta^R \leqq 45° \qquad (3\text{-IV})$$

and

$$15° \leqq \theta^L \leqq 45° \qquad (3\text{-V}).$$

(E3) When the above m is at least 2, $\theta^R_i$ of i-th time (i=2 to m) and $\theta^R_{(i-1)}$ of (i-1)-th time satisfy the following formula (3-VI), and when the above n is at least 2, $\theta^L_j$ of j-th time (j=2 to n) and $\theta^L_{(j-1)}$ of (j-1)-th time satisfy the following formula (3-VII):

$$\theta^R_i \leqq \theta^R_{(i-1)} \qquad (3\text{-VI}),$$

and

$$\theta^L_j \leqq \theta^L_{(j-1)} \qquad (3\text{-VII}).$$

Conditions (A3) and (B3): If the conditions (A3) and (B3) are not satisfied, it is not possible to form the metal layer 24 on a surface of the underlayer 22 covering the top face 16, the side face 18 and the side face 20 of each ridge 12.
Condition (C3): If the condition (C3) is not satisfied, the height Ha of the metal layer 24 formed on the top face of the underlayer 22 covering the top face 16 of each ridge 12 becomes low. Namely, in order to carry out vapor deposition so as to form a metal layer 24 having a sufficiently thick portion projecting outwardly from the side face 18 or the side face 20 of each ridge 12 by a single vapor deposition under the condition (A3) or a single vapor deposition under the condition (B3), it is necessary to make the angle $\theta^R$ and the angle $\theta^L$ large, and as a result, the amount of metal deposited on the top face becomes small.

Further, by carrying out vapor deposition under the condition (A3) and vapor deposition under the condition (B3) alternately, it is possible to avoid uneven vapor deposition of metal, whereby the thicknesses Da1 and Da2 of the portion of the metal layer 24 projecting outwardly from the side face 18 or the side face 20 of each ridge 12 becomes substantially the same.

Condition (D3): At a time of carrying out vapor deposition on ridges 12 having a pitch of the wavelength of light or smaller, since the shape of the metal layer 24 changes depending on the angle $\theta^R$ (or $\theta^L$) of the vapor deposition, there is a case where a metal layer 24 having an appropriate shape cannot be formed under some angle $\theta^R$ (or $\theta^L$) conditions. If the angle $\theta^R$ at the first vapor deposition among m times of the vapor depositions and the angle $\theta^L$ of the first deposition among n times of the vapor depositions are each less than 15°, the metal is vapor-deposited also on the bottom face of each groove 26. If the angle $\theta^R$ at the first vapor deposition among m times of the vapor depositions and the angle $\theta^L$ at the first deposition among n times of the vapor depositions each exceeds 45°, the metal is unevenly vapor deposited, whereby an obliquely inclined metal layer 24 is formed.

Condition (E3): If the condition (E3) is not satisfied, when a portion of the metal layer 24 projecting outwardly from the side face 18 or the side face 20 of each ridge 12 is made to have a predetermined thickness, the height Ha of the metal layer 24 formed on the top face of the underlayer 22 covering the top face 16 of each ridge 12 becomes too low. Further, in a case of making the height Ha of the metal layer 24 on the top face of the underlayer 22 covering the top face 16 of each ridge 12 to be at least 30 nm, the thickness of the portion of the metal layer 24 projecting outwardly from the side face 18 or the side face 20 becomes too thick.

Condition (F3): The vapor deposition process preferably satisfies the following condition (F3).

(F3) The height of the metal layer 24 formed by the first vapor deposition among m times of the vapor depositions under the above condition (A3) and the height of the metal layer 24 formed by the first vapor deposition among n times of the vapor depositions under the above condition (B3) satisfy the following formula (3-III).

$$0.5\ nm \leq Ha' \leq 10\ nm \qquad (3\text{-}III).$$

Here, Ha' is the height of the metal layer 24 covering the top portion of each ridge formed by each vapor deposition.

If the height Ha' of the metal layer 24 becomes too low in the initial vapor depositions, the portion of the metal layer 24 projecting outwardly from the side face 18 or the side face 20 of each ridge 12 may become too thick.

[COMMON TO PROCESSES OF FIRST TO THIRD EMBODIMENTS]

The angle $\theta^R$ (or $\theta^L$) is adjustable by, for example, using the following vapor deposition apparatus.

A vapor deposition apparatus wherein the tilt of a light-transmitting substrate 14 disposed so as to face to a vapor deposition source can be adjusted so that the vapor deposition source is relatively positioned on an extension line in a direction V1 substantially perpendicular to the longitudinal direction of each ridge 12 and at an angle of $\theta^R$ on the side face 18 side to the height direction H of the ridge 12, or in the direction V2 substantially perpendicular to the longitudinal direction L of the ridge 12 and at an angle of $\theta^L$ on the side face 20 side to the height direction H of the ridge 12.

In the process for producing a wire-grid polarizer 10 described above, the metal layer 24, or the underlayer 22 and the metal layer 24 are formed by a vapor deposition method satisfying the above conditions, whereby a wire-grid polarizer 10 can be easily produced.

EXAMPLES

Now, the present invention will be described in further detail with reference to Examples, but the present invention is not limited to these Examples.

Examples 1 to 13 are Examples of the present invention, and Examples 14 to 16 are Comparative Examples.

(DIMENSIONS OF UNDERLAYER AND FINE METALLIC WIRE)

Dimensions of the underlayer and the metal layer (fine metallic wire) are each obtained by measuring the maximum value of the dimension of the underlayer and the fine metallic wire at each of five positions in a transmission type electron microscopic image of a cross section of a wire grid polarizer, and averaging the values of the five positions.

(TRANSMITTANCE)

A solid state laser beam having a wavelength of 405 nm and a semiconductor laser beam having a wavelength of 635 nm are incident from a front surface (a surface on which the metal layer is formed) of a wire grid polarizer, so as to perpendicular to the front surface of the wire grid polarizer, to measure the p-polarized light transmittance and the s-polarized light transmittance.

An example which showed a p-polarized light transmittance of at least 78% at a wavelength of 400 nm or 700 nm is designated as S, an example which showed that of at least 75% and less than 78% is designated as A, and an example which showed that of less than 75% is designated as ×.

(REFLECTIVITY)

A solid state laser beam having a wavelength of 405 nm and a semiconductor laser beam having a wavelength of 635 nm are incident from a front surface or a rear surface (a surface on which no fine metallic wires are formed) of a wire grid polarizer so as to be at an angle of 5° to the front surface or the rear surface of the wire grid polarizer, to measure the s-polarized light reflectivity.

An example which showed a s-polarized light reflectivity of at least 80% from the front surface is designated as S, an example which showed that of at least 80% and less than 82% is designated as A, and an example which showed that of less than 80% is designated as ×.

An example which showed a s-polarized light reflectivity of less than 40% from the rear surface at a wavelength of 400 nm or 700 nm is designated as A, and an example which showed that of at least 40% is designated as ×.

(DEGREE OF POLARIZATION)

The degree of polarization of the wire grid polarizer is calculated by the following formula.

$$\text{Degree of polarization} = ((Tp-Ts)/(Tp+Ts))^{0.5}$$

wherein Tp is the p-polarized light transmittance, and Ts is the s-polarized light transmittance.

An example which showed a degree of polarization of at least 99.7% at a wavelength of 400 nm or 700 nm is designated as S, an example which showed that of at least 99.5% and less than 99.7% is designated as A, and an example which showed a degree of polarization of less than 99.5% is designated as ×.

(PREPARATION OF PHOTOCURABLE COMPOSITION)

60 g of a monomer 1 (NK ester A-DPH, dipentaerythritol hexaacrylate, manufactured by Shin-Nakamura Chemical Co., Ltd.),
40 g of a monomer 2 (NK ester A-NPG, neopentyl glycol diacrylate, manufactured by Shin-Nakamura Chemical Co., Ltd.),
4.0 g of a photopolymerization initiator (IRGACURE 907, manufactured by Ciba Specialty Chemicals),
0.1 g of fluorosurfactant (cooligomer of fluoroacrylate ($CH_2$=CHCOO$(CH_2)_2(CF_2)_8$F) and butyl acrylate, manufactured by Asahi Glass Company, Limited, fluorine content: about 30 mass%, mass-average molecular weight: about 3,000),
1.0 g of a polymerization inhibitor (Q1301, manufactured by Wako Pure Chemical Industries, Ltd.) and
65.0 g of cyclohexane, were put in a four-port flask of 1,000 mL to which a stirrer and a cooling pipe are attached.

In a state that inside of the flask was set at room temperature while light is shielded, stirring was carried out for 1 hour to homogenize the content. Subsequently, while the content of the flask was being stirred, 100 g of a colloidal silica (solid state content: 30 g) was gradually added, and the content of the flask was stirred for 1 hour in a state that inside of the flask was set to room temperature while light is shielded, to homogenize the content. Subsequently, 340 g of cyclohexanone was added, and the content of the flask was stirred for 1 hour in a state that inside of the flask was set to room temperature while light is shielded, to obtain a solution of photocurable composition 1.

EXAMPLE 1

(PREPARATION OF LIGHT-TRANSMITTING SUBSTRATE)

The photocurable composition 1 was applied on a surface of a high-transmitting polyethylene terephthalate (PET) film (Teijin Tetron 03, manufactured by Teijin DuPont, 100 mm × 100 mm) having a thickness of 100 $\mu$m, by a spin coating method, to form a coating film of the photocurable composition 1 having a thickness of 1 $\mu$m.

A quartz mold (50 mm × 50 mm, groove pitch: 150 nm, groove width: 50 nm, groove depth: 100 nm, groove length: 50 mm, cross-sectional shape of groove: rectangular) having a plurality of grooves formed so as to be parallel with one another at a predetermined pitch, was pressed against the coating film of the photocurable composition 1 at 25°C with 0.5 MPa (gauge pressure) so that the grooves contact with the coating film of the photocurable composition 1.

While the above state was maintained, light of a high pressure mercury lamp (frequency: 1.5 kHz to 2.0 kHz, peak wavelengths: 255 nm, 315 nm and 365 nm, radiation energy at 365 nm: 1,000 mJ) was radiated to the photocurable composition 1 for 15 seconds from the quartz mold side, to cure the photocurable composition 1 to produce a tight-transmitting substrate 1 (ridge pitch Pp: 150 nm, ridge width Dp: 50 nm, ridge height: Hp: 100 nm) having a plurality of ridges corresponding to the grooves of the quartz mold. The quarts mold was slowly separated from the light-transmitting substrate.

(FORMATION OF UNDERLAYER AND METAL LAYER)

Employing a vacuum vapor deposition apparatus (SEC-16CM, manufactured by Showa Shinku Co., Ltd.) wherein the tilt of a light-transmitting substrate facing to a vapor deposition source can be adjusted, a metal oxide and a metal were vapor-deposited to cover the ridges of the light-transmitting substrate by an oblique vapor deposition method, to form the underlayer and the metal layer as shown in Fig. 1, thereby to obtain a wire grid polarizer having a rear surface on which a PET film was pasted. At this time, a vapor deposition from a direction V1 (that is, from a side face 18 side) substantially perpendicular to the longitudinal direction L of the ridges and at an angle $\theta^R$ in the side face 18 side to the height direction H of the ridges, and a vapor deposition from a direction V2 (that is, from the side face 20 side) substantially perpendicular to the longitudinal direction L of the ridges and at an angle $\theta^L$ on the other side to the height direction H of the ridges, are carried out alternately so that the angle $\theta^R$ or the angle $\theta^L$ at each vapor deposition and the height H' of the underlayer or the height Ha' of the metal layer formed by each vapor deposition were as shown in Tables 1 and 2. Here, Hx' and Ha' were measured by a film thickness monitor employing a quartz oscillator as a film thickness sensor.

With respect to a wire grid polarizer obtained, dimensions of the underlayer and the metal layer were measured. Table 3 shows the results.

Further, with respect to the wire grid polarizer obtained, the transmittance, the reflectivity, the degree of polarization and the angle dependence were measured. Table 4 shows the results.

EXAMPLE 2

(PREPARATION OF LIGHT-TRANSMITTING SUBSTRATE)

A light-transmitting substrate was prepared in the same manner as Example 1.

(FORMATION OF UNDERLAYER)

Employing an inline type sputtering apparatus (manufactured by Nisshin Seiki K.K.) provided with a load rock mechanism, a metal oxide was vapor-deposited on the entire surface of a face of a light-transmitting substrate on which ridge were formed, to form the underlayer as shown in Fig. 2.

The type of the metal oxide and the height Hx' of the underlayer formed by the sputtering method were as shown in Table 1.

(FORMATION OF METAL LAYER)

Employing a vacuum vapor deposition apparatus (SEC-16CM, manufactured by Showa Shinku Co., Ltd.) wherein the tilt of a light-transmitting substrate facing to a vapor deposition source can be adjusted, a metal was vapor-deposited to cover the ridges of the light-transmitting substrate, to obtain the metal layer shown in Fig. 2, thereby to obtain a wire-grid polarizer having a rear surface on which a PET film was pasted. At this time, a vapor deposition from a direction V1 (that is, from a side face 18 side) substantially perpendicular to the longitudinal direction L of the ridges and at an angle $\theta^R$ on one side to the height direction H of the ridges, and a vapor deposition from a direction V2 (that is, from the side face 20 side) substantially perpendicular to the longitudinal direction L of the ridges and at an angle $\theta^L$ on the other side to the height direction H of the ridges, are carried out alternately so that the vapor deposition source and the angle $\theta^R$ or $\theta^L$ at each vapor deposition and the height Ha' of the metal layer at each vapor deposition were as shown in Tables 2.

With respect to a wire grid polarizer obtained, dimensions of the underlayer and the metal layer were measured. Table 3 shows the results.

Further, with respect to the wire grid polarizer obtained, the transmittance, the reflectivity and the degree of polarization were measured. Table 4 shows the results.

EXAMPLE 3

After alight-transmitting substrate was prepared in the same manner as Example 1, an underlayer as shown in Fig. 3 was formed in the same manner as Example 2 except that the type of metal oxide and the height Hx' of the underlayer formed by the sputtering method were as shown in Table 1.

Subsequently, a metal layer as shown in Fig. 3 was formed in the same manner as Example 2 except that the number of vapor depositions, the vapor deposition source in each vapor deposition, the angle $\theta^R$ or $\theta^L$ and the height Ha' of the metal layer formed by each vapor deposition were as shown in Table 2, to obtain a wire-grid polarizer.

With respect to the wire grid polarizer obtained, dimensions of the underlayer and the metal layer were measured. Table 3 shows the results.

Further, with respect to the wire grid polarizer obtained, the transmittance, the reflectivity and the degree of polarization were measured. Table 4 shows the results.

EXAMPLE 4

After a light-transmitting substrate was prepared in the same manner as Example 1, the underlayer and the metal layer shown in Fig. 1 were formed in the same manner as Example 1 except that the number of vapor depositions, the vapor deposition source, the angle $\theta^R$ or $\theta^L$ at each vapor deposition and the height Hx' of the underlayer or the height Ha' of the metal layer by each vapor deposition were as shown in Table 1 or 2, to obtain a wire-grid polarizer.

With respect to the wire grid polarizer obtained, dimensions of the underlayer and the metal layer were measured. Table 3 shows the results.

Further, with respect to the wire grid polarizer obtained, the transmittance, the reflectivity and the degree of polarization were measured. Table 4 shows the results.

EXAMPLE 5

After a light-transmitting substrate was prepared in the same manner as Example 1, an underlayer as shown in Fig. 2 was formed in the same manner as Example 2 except that the type of metal oxide and the height Hx' of the underlayer formed by the sputtering method were as shown in Table 1.

Subsequently, a metal layer as shown in Fig. 2 was formed in the same manner as Example 2 except that the number of vapor depositions, the vapor deposition source in each vapor deposition, the angle $\theta^R$ or $\theta^L$ and the height Ha' of the metal layer formed by each vapor deposition were as shown in Table 2, to obtain a wire-grid polarizer.

With respect to the wire grid polarizer obtained, dimensions of the underlayer and the metal layer were measured. Table 3 shows the results.

Further, with respect to the wire grid polarizer obtained, the transmittance, the reflectivity and the degree of polarization were measured. Table 4 shows the results.

EXAMPLE 6 to 13

After a light-transmitting substrate was prepared in the same manner as Example 1, an underlayer as shown in Fig. 3 was formed in the same manner as Example 2 except that the type of metal oxide and the height Hx' of the underlayer formed by the sputtering method where as shown in Table 1.

Subsequently, a metal layer as shown in Fig. 3 was formed in the same manner as Example 2 except that the number of vapor depositions, the vapor deposition source in each vapor deposition, the angle $\theta^R$ or $\theta^L$ and the height Ha' of the metal layer formed by each vapor deposition were as shown in Table 2, to obtain a wire-grid polarizer.

With respect to the wire grid polarizer obtained, dimensions of the underlayer and the metal layer were measured. Table 3 shows the results.

Further, with respect to the wire grid polarizer obtained, the transmittance, the reflectivity and the degree of polarization were measured. Table 4 shows the results.

EXAMPLE 14

After a light-transmitting substrate was prepared in the same manner as Example 1, a wire-grid polarizer having no underlayer was obtained in the same manner as Example 1 except that the number of vapor depositions, the vapor deposition source, the angle $\theta^R$ or $\theta^L$ at each vapor deposition and the height Ha' of the metal layer by each vapor deposition were as shown in Table 2.

With respect to the wire grid polarizer obtained, dimensions of the underlayer and the metal layer were measured. Table 3 shows the results.

Further, with respect to the wire grid polarizer obtained, the transmittance, the reflectivity and the degree of polarization were measured. Table 4 shows the results.

EXAMPLE 15

(PREPARATION OF LIGHT-TRANSMITTING SUBSTRATE)

A light-transmitting substrate (ridge pitch Pp: 200 nm, ridge width Dp: 60 nm, ridge height Hp: 100 nm) having a plurality of ridges corresponding to grooves of a silicon mold, was prepared in the same manner as Example 1 except that the silicon mold (20 mm × 20 mm, groove pitch: 200 nm, groove width: 60 nm, groove depth: 100 nm, groove length: 10 mm, cross-sectional shape of groove: rectangular) having a plurality of grooves formed so as to be parallel with one another at a predetermined pitch was employed as a mold.

(FORMATION OF METAL LAYER)

A wire-grid polarizer was obtained in the same manner as Example 1 except that the number of vapor depositions, the vapor deposition source, the angle $\theta^R$ or $\theta^L$ at each vapor deposition and the height Ha' of the metal layer formed by each vapor deposition were the material, the angle and the height as shown in Table 2.

With respect to the wire grid polarizer obtained, dimensions of the underlayer and the metal layer were measured. Table 3 shows the results.

Further, with respect to the wire grid polarizer obtained, the transmittance, the reflectivity and the degree of polarization were measured. Table 4 shows the results.

EXAMPLE 16

On a surface of a high-transmitting polyethylene terephthalate (PET) film (Teijin Tetron 03, manufactured by Teijin DuPont Films Japan Limited, 100 mm × 100 mm) having a thickness of 100 $\mu$m, a $SiO_2$ film having a thickness of 100 nm was formed by a sputtering method.

Subsequently, an Al film having a thickness of 100 nm was formed on the $SiO_2$ film by a sputtering method, to form a multilayer film wherein the $SiO_2$ film and the Al film were laminated on the PET film.

On the Al film, a resist (ZEP520A, manufactured by Zeon Corporation) having a thickness of 100 nm was applied by a spin coating method. By using an electron beam lithography machine (HL800D (50 keV), manufactured by Hitachi High-Technologies Corporation), EB exposure and development were carried out to form a resist film wherein a plurality of grooves (width: 100 nm) were formed in parallel with one another at a predetermined pitch (200 nm).

Subsequently, by using a plasma etching apparatus (RIE-140iPC, manufactured by SAMUKO Inc.), etching was carried out with $SF_6$ to prepare a wire-grid polarizer as shown in Fig. 3 of Patent Document 3.

With respect to the wire grid polarizer obtained, dimensions of the metal layer were measured. Table 3 shows the results.

Further, with respect to the wire grid polarizer obtained, the transmittance, the reflectivity and the degree of polarization were measured. Table 4 shows the results.

TABLE 1

| | Underlayer | | | | | | | | | | |
| | First time | | | | | Second time | | | | | |
| | Material | Method | Direction | θ^R | Hx' | Material | Method | Direction | θ^L | Hx' |
| | | | | (°) | (nm) | | | | (°) | (nm) |
| Ex. 1 | $Al_2O_3$ | Vapor deposition | V1 | 80 | 5 | $Al_2O_3$ | Vapor deposition | V2 | 70 | 5 |
| Ex. 2 | $Al_2O_3$ | Sputtering | | | 5 | - | - | - | - | - |
| Ex. 3 | $Al_2O_3$ | Sputtering | | | 5 | - | - | - | - | - |
| Ex. 4 | $SiO_2$ | Vapor deposition | V1 | 80 | 5 | $SiO_2$ | Vapor deposition | V2 | 70 | 5 |
| Ex. 5 | $SiO_2$ | Sputtering | | | 5 | - | - | - | - | - |
| Ex. 6 | $SiO_2$ | Sputtering | | | 5 | - | - | - | - | - |
| Ex. 7 | $SiO_2$ | Sputtering | | | 10 | - | - | - | - | - |
| Ex.8 | $SiO_2$ | Sputtering | | | 15 | - | - | - | - | - |
| Ex. 9 | $TiO_2$ | Sputtering | | | 5 | - | - | - | - | - |
| Ex. 10 | $TiO_2$ | Sputtering | | | 10 | - | - | - | - | - |
| Ex. 11 | $ZrO_2$ | Sputtering | | | 5 | - | - | - | - | - |
| Ex. 12 | $SiO_2$ | Sputtering | | | 5 | - | - | - | - | - |
| Ex. 13 | $SiO_2$ | Sputtering | | | 5 | - | - | - | - | - |
| Ex. 14 | - | - | - | - | - | - | - | - | - | - |
| Ex. 15 | - | - | - | - | - | - | - | - | - | - |
| Ex. 16 | $SiO_2$ | Sputtering | | | 100 | | | | | |

TABLE 2

| | Fine metallic wire | | | | | | | | | | | |
| --- | --- | --- | --- | --- | --- | --- | --- | --- | --- | --- | --- | --- |
| | 1st vapor deposition | | | | 2nd vapor deposition | | | | 3rd vapor deposition | | | |
| | Material | Direction | $\theta^R$ | Ha' | Material | Direction | $\theta^L$ | Ha' | Material | Direction | $\theta^R$ | Hx' |
| | | | (°) | (nm) | | | (°) | (nm) | | | (°) | (nm) |
| Ex. 1 | Al | V1 | 15 | 15 | Al | V2 | 15 | 20 | Al | V1 | 15 | 5 |
| Ex. 2 | Al | V1 | 70 | 5 | Al | V2 | 65 | 5 | Al | V1 | 15 | 10 |
| Ex. 3 | Al | V1 | 35 | 8 | Al | V2 | 35 | 8 | Al | V1 | 30 | 15 |
| Ex. 4 | Al | V1 | 15 | 15 | Al | V2 | 15 | 20 | Al | V1 | 15 | 5 |
| Ex. 5 | Al | V1 | 70 | 5 | Al | V2 | 65 | 5 | Al | V1 | 15 | 10 |
| Ex. 6 | Al | V1 | 35 | 8 | Al | V2 | 35 | 8 | Al | V1 | 30 | 15 |
| Ex. 7 | Al | V1 | 35 | 8 | Al | V2 | 35 | 8 | Al | V1 | 30 | 15 |
| Ex. 8 | Al | V1 | 35 | 8 | Al | V2 | 35 | 8 | Al | V1 | 30 | 15 |
| Ex. 9 | Al | V1 | 35 | 8 | Al | V2 | 35 | 8 | Al | V1 | 30 | 15 |
| Ex. 10 | Al | V1 | 35 | 8 | Al | V2 | 35 | 8 | Al | V1 | 30 | 15 |
| Ex. 11 | Al | V1 | 35 | 8 | Al | V2 | 35 | 8 | Al | V1 | 30 | 15 |
| Ex. 12 | Al | V1 | 30 | 8 | Al | V2 | 30 | 8 | Al | V1 | 25 | 15 |
| Ex. 13 | Al | V1 | 30 | 8 | Al | V2 | 35 | 8 | Al | V1 | 25 | 15 |
| Ex. 14 | Al | V1 | 80 | 5 | Al | V2 | 70 | 5 | Al | V1 | 15 | 10 |
| Ex. 15 | Al | V1 | 60 | 18 | Al | V2 | 60 | 17 | - | - | - | - |
| Ex. 16 | 100 nm thick Al film was formed by sputtering. | | | | | | | | | | | |

**TABLE 2 (Continued)**

| | Fine metallic wire | | | | | | | |
| | 4th vapor deposition | | | | 5th vapor deposition | | | |
| | Material | Direction | θ^L (°) | Ha' (nm) | Material | Direction | θ^R (°) | Ha' (nm) |
|---|---|---|---|---|---|---|---|---|
| Ex. 1 | - | - | - | - | - | - | - | - |
| Ex. 2 | Al | V2 | 15 | 10 | Al | V1 | 15 | 10 |
| Ex. 3 | Al | V2 | 30 | 14 | - | - | - | - |
| Ex. 4 | - | - | - | - | - | - | - | - |
| Ex. 5 | Al | V2 | 15 | 10 | Al | V1 | 15 | 10 |
| Ex. 6 | Al | V2 | 30 | 14 | - | - | - | - |
| Ex. 7 | Al | V2 | 30 | 14 | - | - | - | - |
| Ex. 8 | Al | V2 | 30 | 14 | - | - | - | - |
| Ex. 9 | Al | V2 | 30 | 14 | - | - | - | - |
| Ex. 10 | Al | V2 | 30 | 14 | - | - | - | - |
| Ex. 11 | Al | V2 | 30 | 14 | - | - | - | - |
| Ex. 12 | Al | V2 | 25 | 15 | - | - | - | - |
| Ex. 13 | Al | V2 | 30 | 15 | - | - | - | - |
| Ex. 14 | Al | V2 | 15 | 10 | Al | V1 | 15 | 10 |
| Ex. 15 | - | - | - | - | - | - | - | - |
| Ex. 16 | - | - | - | - | - | - | - | - |

100 nm thick Al film was formed by sputtering.

TABLE 3

| (nm) | Dx | Dx1 | Dx2 | Hx | Da | Da1 | Da2 | Ha | Ha1 | Ha2 | Pp | Dp | Hp |
|---|---|---|---|---|---|---|---|---|---|---|---|---|---|
| Ex. 1 | 56 | 3 | 3 | 10 | 60 | 5 | 5 | 40 | - | - | 150 | 50 | 100 |
| Ex. 2 | 58 | 4 | 4 | 5 | 62 | 6 | 6 | 40 | - | - | 150 | 50 | 100 |
| Ex. 3 | 58 | 4 | 4 | 5 | 70 | 10 | 10 | 45 | 80 | 80 | 150 | 50 | 100 |

(continued)

| (nm) | Dx | Dx1 | Dx2 | Hx | Da | Da1 | Da2 | Ha | Ha1 | Ha2 | Pp | Dp | Hp |
|---|---|---|---|---|---|---|---|---|---|---|---|---|---|
| Ex. 4 | 54 | 2 | 2 | 10 | 60 | 5 | 5 | 40 | - | - | 150 | 50 | 100 |
| Ex. 5 | 56 | 3 | 3 | 5 | 62 | 6 | 6 | 40 | - | - | 150 | 50 | 100 |
| Ex. 6 | 56 | 3 | 3 | 5 | 70 | 10 | 10 | 45 | 80 | 80 | 150 | 50 | 100 |
| Ex. 7 | 58 | 4 | 4 | 10 | 70 | 10 | 10 | 45 | 75 | 75 | 150 | 50 | 100 |
| Ex. 8 | 58 | 4 | 4 | 15 | 70 | 10 | 10 | 45 | 70 | 70 | 150 | 50 | 100 |
| Ex. 9 | 58 | 4 | 4 | 5 | 70 | 10 | 10 | 45 | 80 | 80 | 150 | 50 | 100 |
| Ex. 10 | 58 | 4 | 4 | 10 | 70 | 10 | 10 | 45 | 75 | 75 | 150 | 50 | 100 |
| Ex. 11 | 58 | 4 | 4 | 5 | 70 | 10 | 10 | 45 | 80 | 80 | 150 | 50 | 100 |
| Ex. 12 | 58 | 4 | 4 | 5 | 65 | 10 | 10 | 45 | 100 | 100 | 150 | 50 | 100 |
| Ex. 13 | 58 | 4 | 4 | 5 | 70 | 10 | 10 | 45 | 100 | 80 | 150 | 50 | 100 |
| Ex. 14 | - | - | - | - | 80 | 15 | 15 | 40 | - | - | 150 | 50 | 100 |
| Ex. 15 | - | - | - | - | 140 | 40 | 40 | 35 | 100 | 40 | 200 | 60 | 100 |
| Ex. 16 | 50 | 0 | 0 | 100 | 50 | 0 | 0 | 100 | 0 | 0 | 150 | 50 | 0 |

TABLE 4

| | 400 nm | | | | 700 nm | | | |
|---|---|---|---|---|---|---|---|---|
| | p-transmittance | s-reflectivity | | Degree of polarization | p-transmittance | s-reflectivity | | Degree of polarization |
| | | Front surface | Rear surface | | | Front surface | Rear surface | |
| Ex. 1 | S | A | - | A | A | A | - | A |
| Ex. 2 | S | A | - | A | A | A | - | A |
| Ex. 3 | S | A | A | A | A | A | A | A |
| Ex. 4 | A | A | - | A | A | A | - | A |
| Ex. 5 | A | A | - | A | A | A | - | A |
| Ex. 6 | A | A | A | A | A | A | A | A |
| Ex. 7 | A | A | A | A | A | A | A | A |
| Ex. 8 | A | A | A | A | A | A | A | A |
| Ex. 9 | S | A | A | A | A | A | A | A |
| Ex. 10 | S | A | A | A | A | A | A | A |
| Ex. 11 | S | A | A | A | A | A | A | A |
| Ex. 12 | S | S | A | S | S | S | A | S |
| Ex. 13 | S | S | A | S | S | S | A | S |
| Ex. 14 | X | A | - | X | X | A | - | A |
| Ex. 15 | X | A | X | X | X | A | X | A |
| Ex. 16 | X | A | A | A | A | A | A | A |

In Examples 1 to 13, since the underlayer made of a metal oxide was formed on the top face of each ridge, the wire-grid polarizer showed a high degree of polarization, a high p-polarized light reflectivity and a high s-polarized light reflectivity.

In Example 14, since there is no underlayer, the p-polarized light reflectivity was low.

In Example 15, that is an Example corresponding to Example 1 of Patent Document 2, since there is no underlayer, the p-polarized light reflectivity was low.

In Example 16, that is an Example corresponding to Patent Document 3, since there is no resin grid, the p-polarized light reflectivity at a short wavelength was low.

INDUSTRIAL APPLICABILITY

The wire-grid polarizer of the present invention is useful as a polarizer for image display devices such as liquid crystal display devices, rear projection TVs or front projectors.

The entire disclosure of Japanese Patent Application No. 2008-180448 filed on July 10, 2008 including specification, claims, drawings and summary is incorporated herein by reference in its entirety.

EXPLANATION OF NUMERALS

10:     Wire-grid polarizer
12:     Ridge
14:     Light-transmitting substrate
16:     Top face of ridge
18:     One side face of ridge
20:     The other side face of ridge
22:     Underlayer
24:     Metal layer
26:     Groove between ridges

**Claims**

1.  A wire-grid polarizer comprising a light-transmitting substrate having a surface on which a plurality of ridges are formed in parallel with one another at a predetermined pitch; an underlayer made of a metal oxide and present at least on the top portion of each ridge; and a fine metallic wire made of a metal layer and present on a surface of the underlayer to cover at least the top portion of each ridge.

2.  The wire-grid polarizer according to Claim 1, wherein the metal layer further present to cover at least a portion of each side face of each ridge.

3.  The wire-grid polarizer according to Claim 1 or 2, wherein the metal layer further present to cover the entire surface of each side face of each ridge.

4.  The wire-grid polarizer according to any one of Claims 1 to 3, wherein the underlayer is further present on the entire surface of each side face of each ridge.

5.  The wire-grid polarizer according to any one of Claims 1 to 4, wherein the metal oxide is $SiO_2$ or $TiO_2$.

6.  The wire-grid polarizer according to any one of Claims 1 to 5, wherein the height of the underlayer on the top portion of each ridge is from 1 to 20 nm.

7.  The wire-grid polarizer according to any one of Claims 1 to 6, wherein the height of the metal layer covering the top portion of each ridge is at least 30 nm.

8.  The wire-grid polarizer according to any one of Claims 1 to 7, wherein the pitch (Pa) of the fine metallic wires is from 50 to 200 nm, and the ratio (Da/Pa) of the width (Da) of each fine metallic wire to the pitch (Pa) is from 0.1 to 0.6.

9.  A process for producing a wire-grid polarizer, comprising:

    vapor-depositing a metal oxide at least on the top portion of each of a plurality of ridges formed in parallel with one another at a predetermined pitch on a surface of a light-transmitting substrate, to form an underlayer made of the metal oxide; and

vapor-depositing a metal on a surface of the underlayer so as to cover at least the top portion of each ridge to form a metal layer to form a fine metallic wire.

10. The process according to Claim 9, wherein the underlayer is formed at least on the top portion of each ridge by an oblique vapor deposition method using a vacuum vapor deposition method.

11. The process according to Claim 9, wherein the underlayer is formed on the entire surface of each ridge and each surface of the light-transmitting substrate between the ridges.

12. The process according to Claim 11, wherein the underlayer is formed by a sputtering method.

13. The process according to any one of Claims 9 to 12, wherein the metal layer is formed to cover at least a part of each side face of each ridge and the top portion of each ridge.

14. The process according to any one of Claims 9 to 13, wherein the metal layer is formed to cover the entire surfaces of each side face of each ridge and the top portion of each ridge.

15. The process according to any one of Claims 9 to 14, wherein the metal layer is formed by an oblique vapor deposition method using a vacuum vapor deposition method.

16. The process according to Claim 15, wherein the metal layer is formed by using the oblique vapor deposition method under the following conditions:

(A) the metal is vapor-deposited from a direction substantially perpendicular to the longitudinal direction of each ridge and at an angle of $\theta^R$ to the height direction of the ridge;

(B) the metal is vapor-deposited from a direction substantially perpendicular to the longitudinal direction of the ridge and at an angle of $\theta^L$ on the opposite side from the angle $\theta^R$ to the height direction of the ridge;

(C) vapor deposition under the above condition (A) and vapor deposition under the above condition (B) are carried out alternately so that the number of vapor depositions under the above condition (A) is m (wherein m is at least 1) and the number of vapor depositions under the condition (B) is n (wherein n is at least 1), and the total (m+n) becomes at least 3;

(D) the angle $\theta^R$ in the first vapor deposition in the m times of vapor depositions under the above condition (A) satisfies the following formula (IV) and the angle $\theta^L$ in the first vapor deposition in the n times of vapor depositions under the above condition (B) satisfies the following formula (V):

$$15° \leq \theta^R \leq 45° \qquad \text{(IV),}$$

and

$$15° \leq \theta^L \leq 45° \qquad \text{(V);}$$

and

(E) when the above m is at least 2, the angle $\theta^R_i$ in the i-th time (wherein i is from 2 to m) and $\theta^R_{(i-1)}$ in the (i-1)-th time satisfy the following formula (VI), and when the above n is at least 2, the angle $\theta^L_j$ in the j-th time (wherein j is from 2 to i) satisfy the following formula (VII):

$$\theta^R_i \leq \theta^R_{(i-1)} \qquad \text{(VI),}$$

and

$$\theta^L_j \leq \theta^L_{(j-1)} \qquad \text{(IV).}$$

$$\theta^L_j \leq \theta^L_{(j-1)} \qquad \text{(IV).}$$

Fig. 1

Fig. 2

Fig. 3

**Fig. 4**

EP 2 299 299 A1

## INTERNATIONAL SEARCH REPORT

| International application No. |
| --- |
| PCT/JP2009/062550 |

A. CLASSIFICATION OF SUBJECT MATTER
*G02B5/30*(2006.01)i, *C23C14/06*(2006.01)i

According to International Patent Classification (IPC) or to both national classification and IPC

B. FIELDS SEARCHED

Minimum documentation searched (classification system followed by classification symbols)
G02B5/30, C23C14/06

Documentation searched other than minimum documentation to the extent that such documents are included in the fields searched
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y<br>A | JP 2006-3447 A  (Sony Corp.),<br>05 January, 2006 (05.01.06),<br>Full text; all drawings<br>(Family: none) | 1-15<br>16 |
| Y<br>A | JP 2005-148506 A  (Hitachi Maxell, Ltd.),<br>09 June, 2005 (09.06.05),<br>Par. Nos. [0016], [0021], [0025] to [0027];<br>Figs. 2, 3<br>(Family: none) | 1-15<br>16 |

☐ Further documents are listed in the continuation of Box C.　　☐ See patent family annex.

| * | Special categories of cited documents: |
| --- | --- |
| "A" | document defining the general state of the art which is not considered   to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>17 August, 2009 (17.08.09) | Date of mailing of the international search report<br>25 August, 2009 (25.08.09) |
| --- | --- |
| Name and mailing address of the ISA/<br>Japanese Patent Office | Authorized officer |
| Facsimile No. | Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005070456 A
- JP 2006003447 A
- JP 2008046637 A
- JP 2008180448 A